(19) Europäisches Patentamt
European Patent Office
Office européen des brevets

(11) EP 1 718 121 B1

(12) **EUROPEAN PATENT SPECIFICATION**

(45) Date of publication and mention of the grant of the patent:
**25.11.2020 Bulletin 2020/48**

(21) Application number: **05709851.9**

(22) Date of filing: **08.02.2005**

(51) Int Cl.:
***H01L 51/54*** *(2006.01)* *C09K 11/06* *(2006.01)*

(86) International application number:
**PCT/JP2005/001799**

(87) International publication number:
**WO 2005/076669 (18.08.2005 Gazette 2005/33)**

(54) **ORGANIC ELECTROLUMINESCENT DEVICE**

ORGANISCHES ELEKTROLUMINESZENZBAUELEMENT

DISPOSITIF ELECTROLUMINESCENT ORGANIQUE

(84) Designated Contracting States:
**BE DE FR GB NL**

(30) Priority: **09.02.2004 JP 2004032542**

(43) Date of publication of application:
**02.11.2006 Bulletin 2006/44**

(73) Proprietor: **IDEMITSU KOSAN CO., LTD.**
**Tokyo 100-8321 (JP)**

(72) Inventors:
- **MATSUURA, Masahide**
  **Chiba 2990293 (JP)**
- **IWAKUMA, Toshihiro**
  **Chiba 2990293 (JP)**
- **YAMAMICHI, Keiko**
  **Chiba 2990293 (JP)**
- **HOSOKAWA, Chishio**
  **Chiba 2990293 (JP)**

(74) Representative: **Gille Hrabal**
**Brucknerstrasse 20**
**40593 Düsseldorf (DE)**

(56) References cited:
**JP-A- 2002 100 476**
**JP-A- 2002 158 091**
**JP-A- 2002 343 572**
**JP-A- 2003 317 966**
**JP-A- 2004 006 287**
**JP-A- 2004 022 434**
**US-A1- 2002 055 014**
**US-A1- 2002 096 955**
**US-A1- 2003 072 965**
**US-A1- 2003 205 696**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 718 121 B1

Printed by Jouve, 75001 PARIS (FR)

## Description

TECHNICAL FIELD

The invention relates to an organic electroluminescent device (hereinafter abbreviated as "organic EL device") . More particularly, the invention relates to a highly efficient organic EL device.

BACKGROUND ART

An organic EL device using an organic substance is a promising solid-state emitting type inexpensive and large full-color display device, and has been extensively developed. An EL device generally includes an emitting layer and a pair of opposing electrodes holding the emitting layer therebetween.

In the EL device, electrons and holes are injected into the emitting layer respectively from a cathode and an anode upon application of an electric field between the electrodes. The electrons and the holes recombine in the emitting layer to produce an excited state, and the energy is emitted as light when the excited state returns to the ground state. The EL device emits light by utilizing this phenomenon.

Various configurations have been known as the configuration of the organic EL device. For example, use of an aromatic tertiary amine as a material for a hole-transporting layer has been disclosed for an organic EL device having the device configuration of "indium tin oxide (ITO)/hole-transporting layer/emitting layer/cathode" (see JP-A-63-295695). This device configuration achieves a high luminance of several hundreds cd/$m^2$ at an applied voltage of 20 V or less.

It has been reported that an emission efficiency of about 40 lm/W or more is achieved at a luminance equal to or less than several hundreds cd/$m^2$ by using an iridium complex (phosphorescent dopant) as a dopant for an emitting layer (see Tsutsui et al., "Japanese Journal of Physics", Vol. 38 (1999), p. 1502-1504).

However, since most phosphorescent organic EL devices emit green light, a phosphorescent organic EL device which emits blue light has been demanded. Moreover, an increase in the efficiency of the phosphorescent organic EL device has also been demanded.

When applying the organic EL device to a flat panel display or the like, the organic EL device is required to exhibit improved emission efficiency and reduced power consumption. However, the above-mentioned device configuration has a disadvantage in that the emission efficiency significantly decreases accompanying an increase in luminance. Therefore, it is difficult to reduce the power consumption of the flat panel display.

On the other hand, technologies relating to a hole barrier layer, which is one of the layers of the organic EL device, have been disclosed (see United States Patent No. 6,097,147 and JP-A-2002-203683). These technologies improve current efficiency by using an organic compound having a high ionization potential as a material for the hole barrier layer. However, the drive voltage of the organic EL device is disadvantageously increased due to accumulated holes.

US 2002/0055014 A1 discloses an organic electroluminescent device having a multilayer structure comprising at least an emitting layer and an electron-transporting layer between a cathode and an anode. At least one of the organic layers comprises a heterocyclic compound having at least two hetero atoms and a phosphorescent compound. Example 1 discloses a layer structure of hole transporting layer (TPD)/emitting layer (host and dopant)/interface layer (BCP)/ electron transporting layer (Alq). The electron-transporting layer which contacts the emitting layer is formed of BCP (bathocuproine) . It is expected by the skilled person that the hole mobility of BCP cannot be measured or, in case it could be measured, it would not go beyond 1.0 x $10^{-7}$ (V s).

US 2003/0072965 A1 discloses a light-emitting device comprising a pair of electrodes and one or more organic layers disposed therebetween, the one or more light-emitting layers comprising a light-emitting layer, wherein at least one of the organic layers comprises a heterocyclic compound having four nitrogen atoms. Example 2 of the document has the same layer structure as Example 1 of US 2002/0055014 A discussed above.

US 2003/0205696 A1 discloses a further organic light emitting system. The host material comprises a compound having a carbazole core with an electron-donating species boded to the nitrogen. The document discloses a layer structure of hole transporting layer ($\alpha$-NPB)/emitting layer (host-dopant)/exciton-blocking layer (BCP)/electron transporting layer (Alq). The electron-transporting layer is formed of BCP.

US 2002/0096995 A1 discloses another organic light-emitting device wherein an ionization potential of the electron-transporting material is 5.9 eV or more. Example 9 describes a structure ITO/TPD/CBP:Ir-complex/TBBi/LiF/Al. D3 does not explicitly mention the requirements of hole mobility of the electron transport layer.

The invention was achieved in view of the above-described situation. An object of the invention is to provide a phosphorescent organic EL device which is driven at a low voltage and exhibits high current efficiency.

DISCLOSURE OF THE INVENTION

According to the invention, the following organic EL device is provided.

1. An organic EL device (100) having a multilayer structure comprising at least an emitting layer (15) and one or more electron-transporting layer(s) (16) between a cathode (17,18) and an anode (12), the triplet energy gap ($Eg^T$) of a host material forming the emitting layer (15) being 2.52 eV or more and 3.7 eV or less, an electron-transporting material forming the electron-transporting layer (16) which contacts the emitting layer (15) being different from the host material, and having a hole mobility measured by the time of flight method ($\mu(h)$) > $1.0 \times 10^{-7}$ $cm^2/(V \cdot s)$ at a field intensity of $10^5$ to $10^7$ V/cm, , and the emitting layer comprising a phosphorescent metal complex compound containing a heavy metal, wherein
the electron-transporting material forming the electron-transporting layer (16) which contacts the emitting layer (15) has one or more of the following structures (1) to (3) :
five-membered ring or six-membered ring containing =N-skeleton (1),

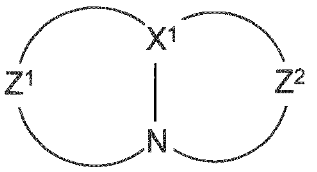

(2)

wherein $X^1$ is a carbon atom or a nitrogen atom, and $Z^1$ and $Z^2$ are independently atom groups which can form a nitrogen-containing hetero ring,

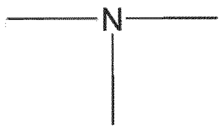

(3)

.

2. The organic EL device (100) according to 1, wherein the ionization potential (Ip) of the electron-transporting material forming the electron-transporting layer (16) is 5.6 eV or more and less than 6.0 eV.
3. The organic EL device (100) according to 1 , wherein the electron-transporting material has a nitrogen-containing aromatic polycyclic group containing a five-membered ring or six-membered ring, and when the group contains a plurality of nitrogen atoms, the organic compound has a skeleton containing the nitrogen atoms in non-adjacent bonding positions.

Further preferred embodiments are defined in claims 4 to 12.

In the organic EL device according to the invention, the host material forming the emitting layer is the major material for the emitting layer, and the phosphorescent metal complex compound containing a heavy metal functions as a luminescent dopant.

The electron-transporting layer is positioned on the side of the cathode between the cathode and the anode.

In the invention, the organic EL device according to 1 includes at least one electron-transporting layer. It is preferable that the expression relating to $\Delta Ip$ be satisfied when the number of electron-transporting layers is one. When the number of electron-transporting layers is plural, it is preferable that at least the expression relating to $\Delta Ip$ be satisfied. It is more preferable that at least two adjacent electron-transporting layers satisfy the expression relating to $\Delta Ip'$. It is still more preferable that all the adjacent electron-transporting layers satisfy the expression relating to $\Delta Ip'$. This also applies to the case where the number of emitting layers is plural.

The invention provides, a phosphorescent organic EL device, particularly emitting light in a blue region, which is driven at a low voltage and exhibits high current efficiency.

BRIEF DESCRIPTION OF THE DRAWINGS

FIG. 1 is a view showing organic EL devices according to Examples 1 to 6.

BEST MODE FOR CARRYING OUT THE INVENTION

An organic EL device according to the invention has a multilayer structure including at least an emitting layer and an electron-transporting layer between a cathode and an anode. The electron-transporting layer contacts the emitting layer. The emitting layer and the electron-transporting layer may respectively have a single-layer configuration or a multilayer configuration.

In the organic EL device according to the invention, a host material forming the emitting layer has a triplet energy gap ($Eg^T$) of 2.52 eV or more and 3.7 eV or less, preferably 2.75 eV or more and 3.7 eV or less, still more preferably 2.80 eV or more and 3.7 eV or less, particularly preferably 2.9 eV or more and 3.7 eV or less, and even more preferably 3.3 eV or more and 3.7 eV or less. A host material having a triplet energy gap within the above range allows a luminescent dopant (described later) of an arbitrary color (blue to red) which may be used in the invention to efficiently emit light.

In the organic EL device according to the invention, an electron-transporting material forming the electron-transporting layer differs from the host material and has hole-transporting properties as defined in claim 1 by the hole mobility. By said hole mobility in the electron-transporting layer hole accumulation due to the difference in ionization potential between the emitting layer and the electron-transporting layer can be prevented. As a result, an increase in drive voltage can be suppressed.

The statement "the electron-transporting material has hole-transporting properties" means that hole mobility can be measured for the electron-transporting material.

The hole mobility is measured by a time of flight method (method which calculates hole mobility from measured charge transit time in an organic film) . In the time of flight method, light having a wavelength absorbed by an organic layer is irradiated to a structure including "electrode/organic layer (layer formed of organic material forming electron-transporting layer)/electrode" to measure the transient current time properties (transit time), and the hole mobility is calculated using the following expression. Note that electron mobility can also be measured by this method.

$$\text{Mobility} = (\text{thickness of organic film})^2 / (\text{transit time} \cdot \text{applied voltage})$$

$$\text{Field intensity} = (\text{voltage applied to device}) / (\text{thickness of organic layer})$$

In the invention, the electron-transporting material forming the electron-transporting layer which contacts the emitting layer has a hole mobility ($\mu$(h)) measured by the time of flight method of $1.\ 0\times10^{-7}$ $cm^2$/ (V·s) <$\mu$ (h) at a field intensity of $10^5$ to $10^7$ V/cm. It is particularly preferable that it has a hole mobility of more than $1.0\times10^{-5}$ $cm^2$/(V·s).

In the organic EL device according to the invention, the emitting layer includes a phosphorescent metal complex compound (luminescent dopant) containing a heavy metal.

The invention is characterized in that the luminescent dopant emits light in the organic EL device due to the triplet energy gap.

This allows the hole-electron recombination energy in the organic EL device to be more efficiently transferred to the luminescent dopant to contribute to emission of light.

The ionization potential of the electron-transporting material forming the electron-transporting layer is preferably 5.6 eV or more and less than 6.0 eV.

The difference between the ionization potential of the host material forming the emitting layer and the ionization potential of the electron-transporting material forming the electron-transporting layer which contacts the emitting layer ($\Delta$Ip = Ip (electron-transporting material) - Ip (host material)) is preferably -0.2 eV < $\Delta$Ip < 0.4 eV, more preferably -0.2 eV < $\Delta$Ip < 0.2 eV.

If the difference $\Delta$Ip is in this range, hole accumulation due to the difference in ionization potential between the emitting layer and the electron transporting layer can be prevented. As a result, an increase in drive voltage can be suppressed.

When the organic EL device according to the invention includes a plurality of (N) electron transporting layers, the difference ($\Delta$Ip') in ionization potential between the electron-transporting materials forming two adjacent layers of the electron-transporting layers represented by the following expression is preferably -0.2 eV < $\Delta$Ip' < 0.4 eV, and still more preferably -0.2 eV < $\Delta$Ip' < 0.2 eV.

$$\Delta Ip' = Ip\ (i) - Ip\ (i+1)$$

Ip (i) : ionization potential of electron-transporting material forming i-th (i is an integer of 1 or more and (N-1) or less) electron-transporting layer from the side of the emitting layer

If ΔIp' is in this range, since a hole barrier which may cause hole accumulation is reduced, the drive voltage can be reduced, whereby a high luminous efficiency can be obtained.

When the organic EL device according to the invention includes a plurality of electron transporting layers, the optical energy gap (Eg) of the electron-transporting material forming each electron-transporting layer is preferably equal to or smaller than the optical energy gap (Eg) of the electron-transporting material forming the adjacent electron-transporting layer nearer to the emitting layer. That is, it is preferable that N electron transporting layers satisfy the following relationship.

$$Eg\ (N) \leq Eg\ (N-1) \leq \cdot\cdot \leq Eg\ (2) \leq Eg\ (1) \qquad (i)$$

Eg (x) : optical energy gap of x-th (x is an integer of 1 or more and N or less) electron transporting layer from the side of the emitting layer

When the organic EL device according to the invention includes a plurality of electron transporting layers, the triplet energy gap ($Eg^T$) of the electron-transporting material forming each electron-transporting layer is preferably equal to or smaller than the triplet energy gap ($Eg^T$) of the electron-transporting material forming the adjacent electron-transporting layer nearer to the emitting layer. That is, it is preferable that N electron transporting layers satisfy the following relationship.

$$Eg^T\ (N) \leq Eg^T\ (N-1) \leq \cdot\cdot \leq Eg^T\ (2) \leq Eg^T\ (1) \qquad (ii)$$

$Eg^T$ (x): triplet energy gap of x-th (x is an integer of 1 or more and N or less) electron transporting layer from the side of the emitting layer

The organic EL device according to the invention preferably satisfies the following expression when the triplet energy gap of the luminescent dopant of the emitting layer is indicated by $Eg^T$ (dopant).

$$Eg^T\ (1) > Eg^T\ (dopant) \qquad (iii)$$

$Eg^T$ (1) : triplet energy gap of electron transporting layer which contacts the emitting layer

The recombination energy in the emitting layer can be prevented from diffusing into the electron transporting layer by satisfying the above expressions (i) to (iii), whereby the energy of the host material is efficiently transferred to the luminescent dopant. As a result, a high current efficiency can be realized.

The host material and the luminescent dopant used for the organic EL device according to the invention are not particularly limited insofar as the above-described conditions are satisfied.

As preferable examples of the host material, compounds exhibiting excellent thin film formability, such as amine derivatives, carbazole derivatives, oxadiazole derivatives, triazole derivatives, benzoxazole type, benzothiazole type, and benzimidazole type fluorescent whitening agents, metal chelate oxanoid compounds, and styryl compounds, can be given. In the invention, an electron transporting material described later may be used as the host material.

It is preferable that the luminescent dopant function as a luminescent dopant which emits light from the triplet state at room temperature. As preferable examples of the heavy metal contained in the dopant, Ir, Pt, Pd, Ru, Rh, Mo, and Re can be given. As examples of the ligand to the heavy metal, a ligand which is coordinated or bonded to a metal at C or N (CN ligand) and the like can be given. As specific examples of the ligand, the following compounds and substituted derivatives thereof can be given.

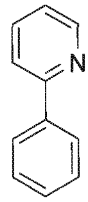
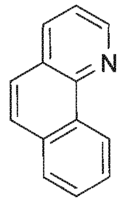
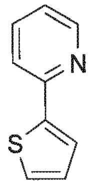
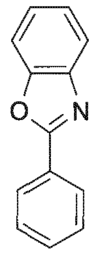

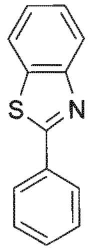
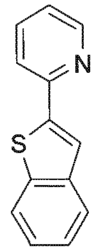
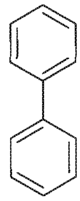
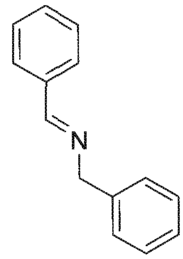

As examples of the substituent of the substituted derivatives, an alkyl group, alkoxy group, phenyl group, polyphenyl group, naphthyl group, fluoro (F) group, trifluoromethyl ($CF_3$) group, and the like can be given.

As preferable examples of a blue light emitting ligand, the following compounds and the like can be given.

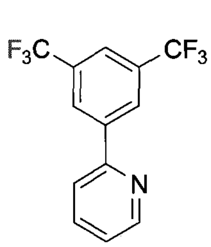
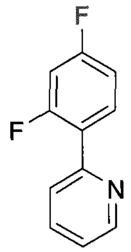
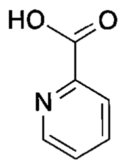

The electron-transporting material is a compound having one or more of the following structures (1) to (3).

Five-membered ring or six-membered ring containing =N- skeleton (1)

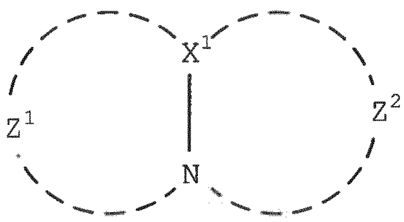
(2)

,

wherein $X^1$ is a carbon atom or a nitrogen atom, and $Z^1$ and $Z^2$ are independently atom groups which can form a nitrogen-containing hetero ring.

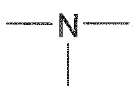
(3)

The electron-transporting material is more preferably an organic compound in which one or more of the structures (1) to (3) form a nitrogen-containing aromatic polycyclic group containing a five-, six-, seven-, or eight-membered ring,

and preferably a five- or six-membered ring, provided that, when the group contains a plurality of nitrogen atoms, the organic compound has a skeleton containing the nitrogen atoms in non-adjacent bonding positions.

As such a compound, a compound having a carbazolyl group, pyridyl group, pyrimidinyl group, pyrazinyl group, triazinyl group, quinoxalyl group, quinolyl group, imidazolyl group, triazolyl group, tetrazolyl group, oxadiazolyl group, thiadiazolyl group, or oxatriazolyl group (each group may have a substituent) is preferable.

As specific examples of such a compound, compounds having a structure shown by the following formula (4) can be given.

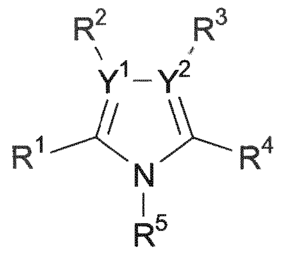

(4)

wherein $R^1$ to $R^5$ represent group bonding positions, provided that $R^1$ and $R^2$, $R^3$ and $R^4$, and $R^2$ and $R^3$ may form a ring, and $Y^1$ and $Y^2$ individually represent a carbon atom or a nitrogen atom (excluding the case where both of $Y^1$ and $Y^2$ represent nitrogen atoms), provided that $R^2$ or $R^3$ does not exist when $Y^1$ or $Y^2$ represents a nitrogen atom.

It is also preferable that the electron-transporting material be a compound in which at least one of $R^1$, $R^4$, and $R^5$ in the formula (4) is a nitrogen atom or an aromatic ring, and the skeleton shown by the formula (4) is bonded to at least one skeleton shown by the formula (4) through at least one nitrogen atom or aromatic ring; or a compound in which at least one of $R^1$, $R^4$, and $R^5$ in the formula (4) is a nitrogen atom or an aromatic ring and the skeleton shown by the formula (4) is bonded to at least one skeleton shown by the formula (4) through at least one nitrogen atom or aromatic ring, and an alicyclic compound.

Specific examples of the compound having the structure shown by the formula (4) are given below.

In the invention, the skeleton groups shown by the following formulas are called a tetrahydrocarbazolyl group.

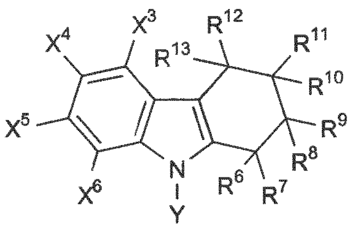

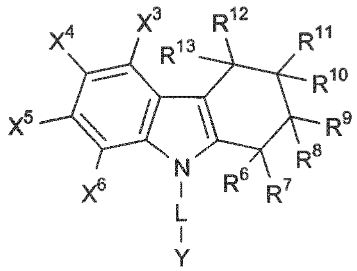

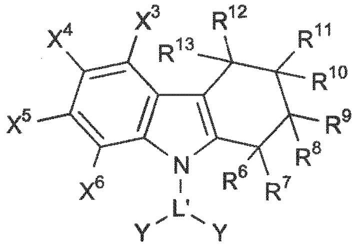

wherein Y represents a substituted or unsubstituted aryl group having 6 to 40 carbon atoms, substituted or unsubstituted heterocyclic group having 3 to 40 carbon atoms, substituted or unsubstituted linear or branched alkyl group having 1 to 30 carbon atoms, or substituted or unsubstituted cycloalkyl group having 5 to 40 carbon atoms.

L represents a substituted or unsubstituted arylene group having 6 to 40 carbon atoms, substituted or unsubstituted divalent heterocyclic group having 3 to 40 carbon atoms, substituted or unsubstituted linear or branched alkylene group having 1 to 30 carbon atoms, or substituted or unsubstituted cycloalkylene group having 5 to 40 carbon atoms.

L' represents a substituted or unsubstituted trivalent aryl group having 6 to 40 carbon atoms, substituted or unsubstituted trivalent heterocyclic group having 3 to 40 carbon atoms, substituted or unsubstituted linear or branched trivalent alkyl group having 1 to 30 carbon atoms, or substituted or unsubstituted trivalent cycloalkyl group having 5 to 40 carbon atoms.

$X^3$ to $X^6$ individually represent a hydrogen atom, Y-, Y-L-, or Y-L'(-Y)- (Y, L, and L' are the same as defined above).

$R^6$ to $R^{13}$ individually represent a hydrogen atom, halogen atom, cyano group, silyl group, substituted or unsubstituted amino group, substituted or unsubstituted aryl group having 6 to 40 carbon atoms, substituted or unsubstituted aryloxy group having 6 to 40 carbon atoms, substituted or unsubstituted heterocyclic group having 3 to 40 carbon atoms, substituted or unsubstituted linear or branched alkyl group having 1 to 30 carbon atoms, substituted or unsubstituted alkoxy group having 1 to 30 carbon atoms, substituted or unsubstituted aralkyl group having 7 to 40 carbon atoms, or substituted or unsubstituted cycloalkyl group having 5 to 40 carbon atoms.

Examples of the substituted or unsubstituted aryl group of Y include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, fluorenyl, perfluoroaryl, 1,1';3',1"-terphenyl-5'-yl, 1,1';3',1"-terphenyl-2'-yl, and 1,1';3',1"-terphenyl-4'-yl.

Examples of the substituted or unsubstituted heterocyclic group of Y include pyrrole, pyridine, pyrimidine, pyrazine, triazine, aziridine, azaindolizine, indolizine, imidazol, indole, isoindole, indazole, purine, pteridine, and β-carboline.

Examples of the substituted or unsubstituted alkyl group of Y include methyl, trifluoromethyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, and 1,2,3-trinitropropyl groups.

Examples of the substituted or unsubstituted cycloalkyl group of Y include cyclopentyl, cyclohexyl, 4-methylcyclohexyl, adamantyl, and norbornyl.

Examples of the substituted or unsubstituted arylene group of L include bivalent groups of the above examples of the substituted or unsubstituted aryl group.

Examples of the bivalent substituted or unsubstituted heterocyclic group with 3 to 40 carbon atoms of L include bivalent or more groups of the above examples of the substituted or unsubstituted heterocyclic group.

Examples of the substituted or unsubstituted alkylene group of L include bivalent groups of the above examples of the substituted or unsubstituted alkyl group.

Examples of the substituted or unsubstituted cycloalkylene group of L include bivalent groups of the above examples of the substituted or unsubstituted cycloalkyl group.

Examples of L' include trivalent groups of the above examples of Y.

Examples of the halogen atom of $R^6$ to $R^{13}$ include fluorine, chlorine, bromine, and iodine.

Examples of the substituted or unsubstituted aryl group of $R^6$ to $R^{13}$ are the same as the above examples for Y.

The substituted or unsubstituted aryloxy groups of $R^6$ to $R^{13}$ are represented by -OP. Examples of P include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-l-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl-1-indolyl, 4-t-butyl-1-indolyl, 2-t-butyl-3-indolyl, and 4-t-butyl-3-indolyl groups.

Examples of the substituted or unsubstituted heterocyclic, alkyl and cycloalkyl groups of $R^6$ to $R^{13}$ are the same as the above examples for Y.

The substituted or unsubstituted alkoxy groups of $R^6$ to $R^{13}$ are represented by -OQ. Examples of Q are the same as the above substituted or unsubstituted alkyl groups for Y.

Examples of the substituted or unsubstituted aralkyl group of $R^6$ to $R^{13}$ include benzyl, 1-phenylethyl, 2-phenylethyl, 1-phenylisopropyl, 2-phenylisopropyl, phenyl-t-butyl, α-naphthylmethyl, 1-α-naphthylethyl, 2-α-naphthylethyl, 1-α-naphthylisopropyl, 2-α-naphthylisopropyl, β-naphthylmethyl, 1-β-naphthylethyl, 2-β-naphthylethyl, 1-β-naphthylisopropyl, 2-β-naphthylisopropyl, 1-pyrrolylmethyl, 2-(1-pyrrolyl)ethyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, 1-chloro-2-phenylisopropyl, and trityl groups.

The electron-transporting material or the host material is preferably a compound having at least one group selected from a carbazolyl group and a tetrahydrocarbazolyl group. The electron-transporting material or the host material is still more preferably a compound having one or two groups selected from a carbazolyl group and a tetrahydrocarbazolyl group. The electron-transporting material or the host material may further have a nitrogen-containing hetero ring group.

Further detailed examples of the compound shown by the formula (4) are disclosed in Japanese Patent Application No. 2002-305375.

The electron-transporting material or the host material may be a compound having one of the following structures.

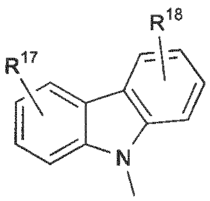
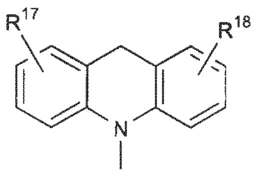
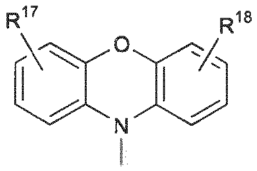
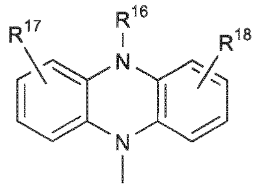

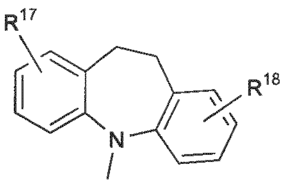
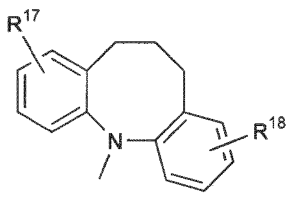
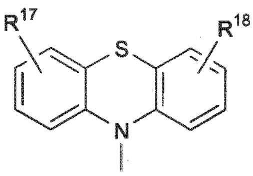
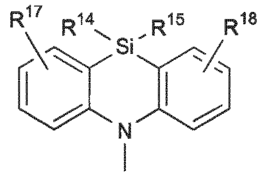

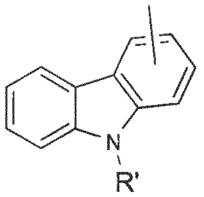
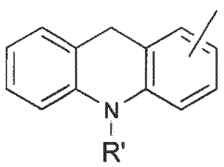
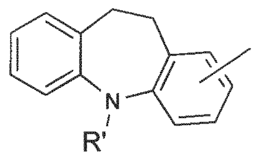
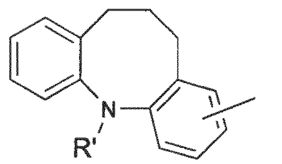

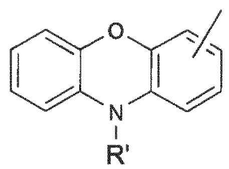
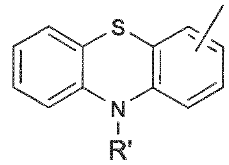
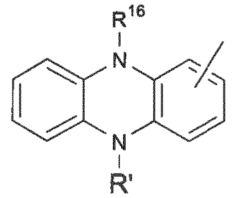
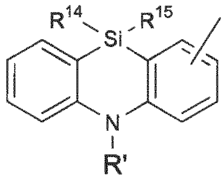

$R^{14}$ to $R^{18}$ individually represent a hydrogen atom or a substituent having 1 to 40 carbon atoms, provided that $R^{14}$ and $R^{15}$ may bond to form a saturated or unsaturated cyclic structure, and R' represents an alkyl group or an aryl group.

The alkyl group represented by R' is preferably a methyl group or an ethyl group. The aryl group represented by R' is preferably a phenyl group.

The electron-transporting material or the host material may be an organic compound shown by the following formula (5).

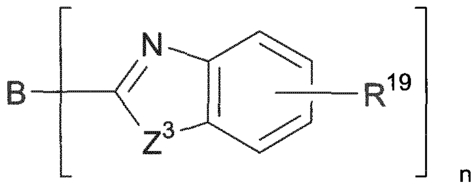

(5)

wherein n represents an integer from 3 to 8, $Z^3$ represents O, $NR^{20}$, or S, $R^{19}$ and $R^{20}$ individually represent a hydrogen atom, an alkyl group having 1 to 24 carbon atoms such as a propyl group, t-butyl group, or heptyl group, an aryl group or a hetero atom-substituted aryl group having 5 to 20 carbon atoms such as a phenyl group, naphthyl group, furyl group, thienyl group, pyridyl group, quinolyl group, or another heterocyclic ring group, a halogen group such as a chloro group or fluoro group, or an atom necessary to complete a condensed aromatic ring, and B represents a bond unit formed of an alkyl group, aryl group, substituted alkyl group, or substituted aryl group which bonds a plurality of benzazoles in a conjugated or nonconjugated manner.

Benzimidazole derivatives disclosed in Japanese Patent Application No. 2003-067847, metal complexes disclosed in United States Patent No. 5,141,671, and the like may also be used.

A compound having a carbazolyl group can also be given as a preferable electron-transporting material. An organic compound having a carbazolyl group and a substituted or unsubstituted pyridyl group, pyrazyl group, pyrimidyl group, triazyl group, amino group, or oxadizole group is more preferable.

As specific examples of such a compound, compounds disclosed in Japanese Patent Application Nos. 2002-071398, 2002-081234, 2002-071397, 2002-080817, 2002-305375, 2002-360134, and the like can be given.

Examples of the compound having a carbazolyl group are given below.

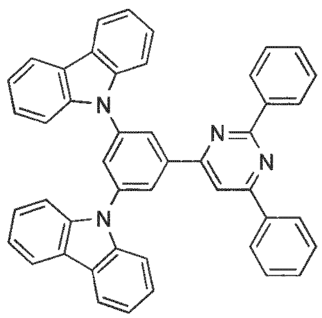

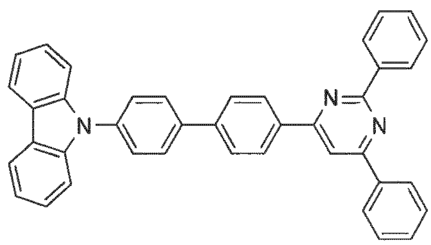

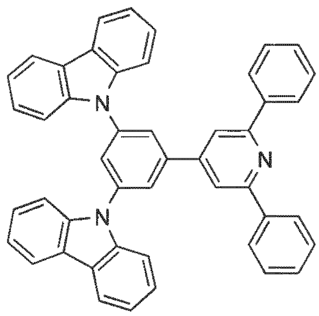

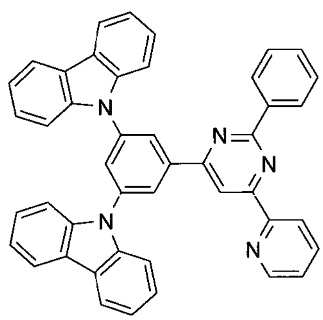

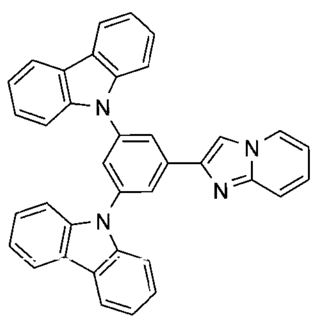

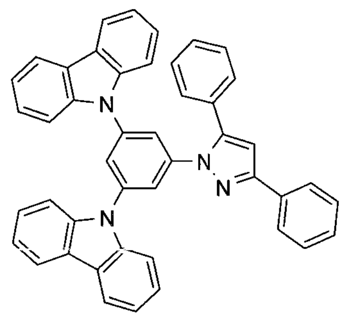

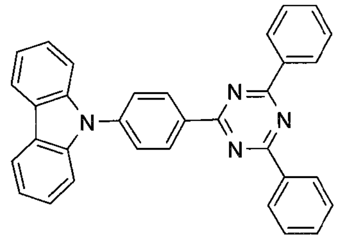
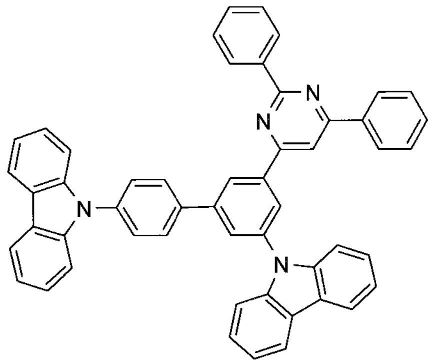
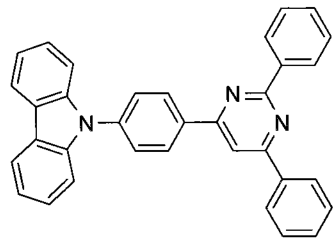

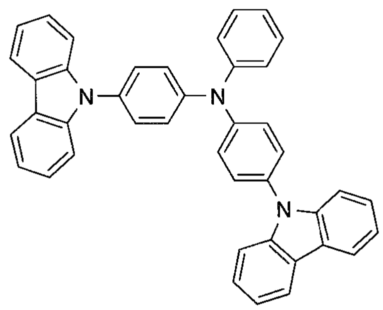
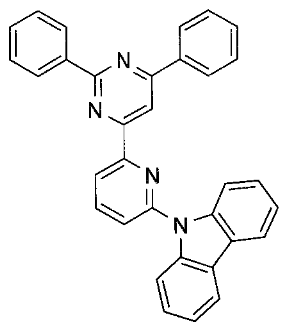
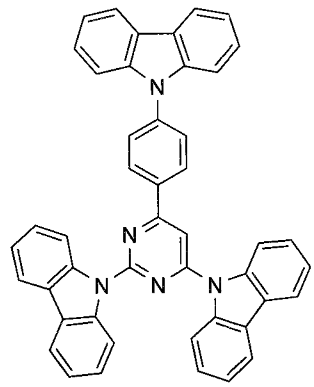

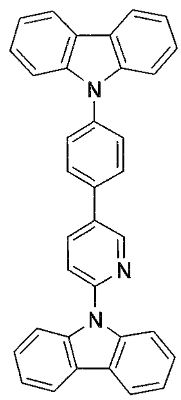
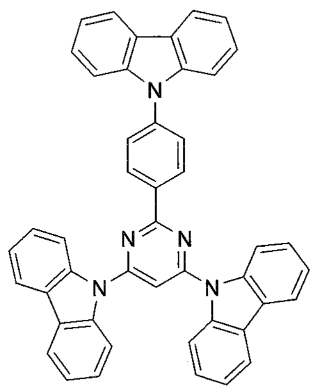
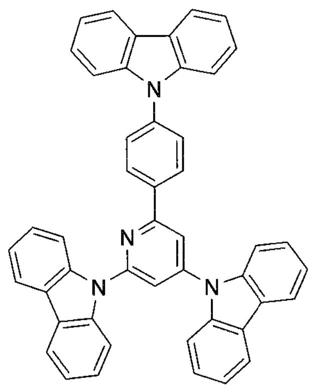

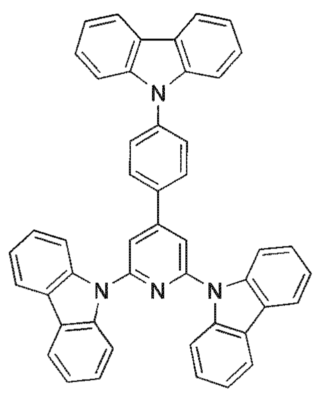
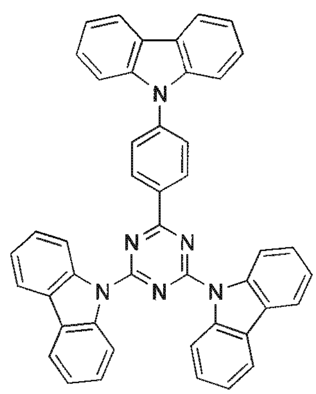
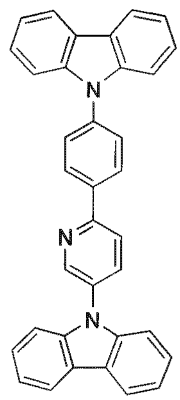

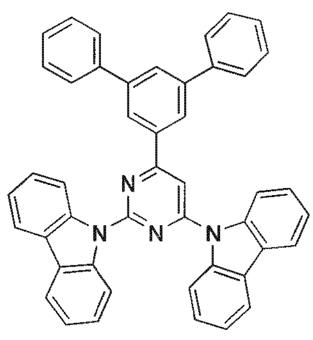
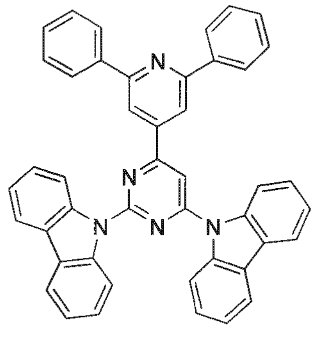

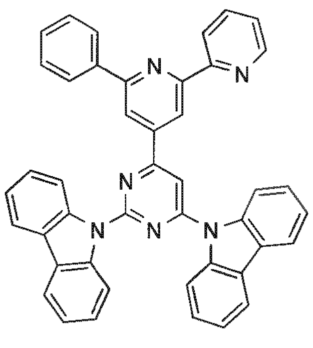
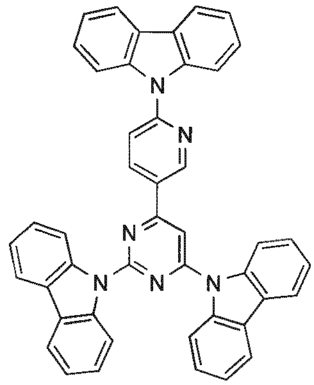

Compounds having one carbazolyl group and compounds having one carbazolyl group and a nitrogen-containing hetero ring group disclosed in Japanese Patent Application No. 2002-299810 are also preferable. Each of the carbazolyl group and the nitrogen-containing hetero ring group may or may not be substituted.

A compound shown by the following formula can be given as such a compound.

$$Cz\text{-}A$$

wherein Cz represents a substituted or unsubstituted arylcarbazolyl group or carbazolylalkylene group, and A represents a group shown by the following formula.

$$(M)p\text{-}(E)q\text{-}(M')r$$

wherein M and M' individually represent nitrogen-containing heteroaromatic rings having 2 to 40 carbon atoms which form a substituted or unsubstituted ring, M and M' may be the same or different, E represents a single bond, a substituted or unsubstituted arylene group having 6 to 30 carbon atoms, substituted or unsubstituted cycloalkylene group having 5 to 30 carbon atoms, or substituted or unsubstituted divalent heteroaromatic ring having 2 to 30 carbon atoms, p represents an integer from 0 to 2, q represents an integer of 1 to 2, and r represents an integer from 0 to 2, provided that "p+r" is one or more.

Note that Cz is bonded to M, E, or M'.

As specific examples of such a compound, ETM_No. 3, ETM_No. 4, ETM_No5, ETM_No. 10, and ETM_No. 11 described in the examples, and the following compounds having a carbazolyl group and a nitrogen-containing hetero ring group which are given as specific examples in pages 13 to 19 of Japanese Patent Application No. 2002-299810 can be given.

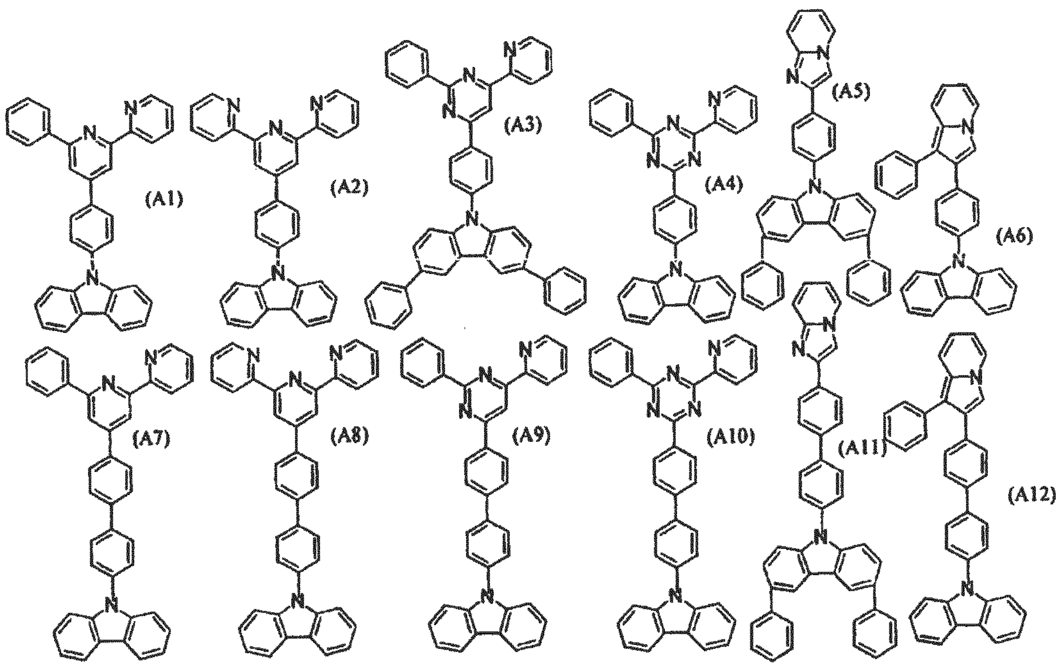

(A1) (A2) (A3) (A4) (A5) (A6)

(A7) (A8) (A9) (A10) (A11) (A12)

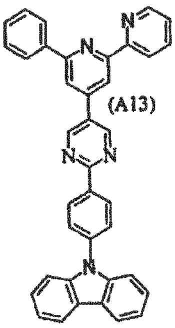
(A13)

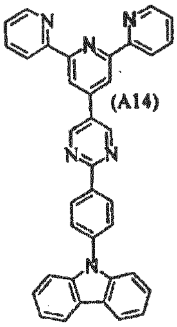
(A14)

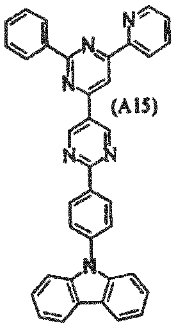
(A15)

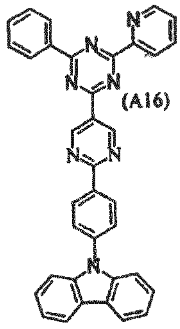
(A16)

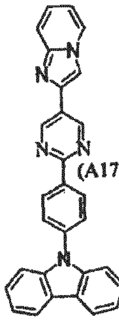
(A17)

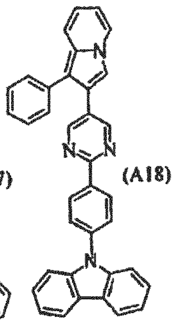
(A18)

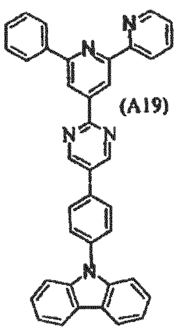
(A19)

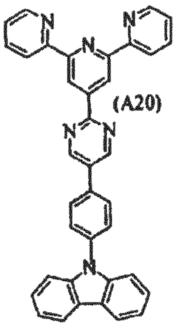
(A20)

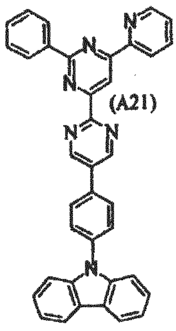
(A21)

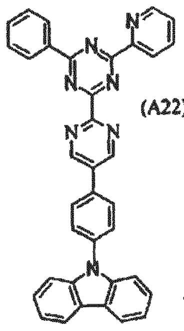
(A22)

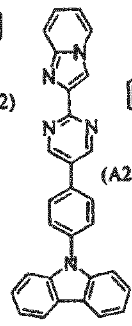
(A23)

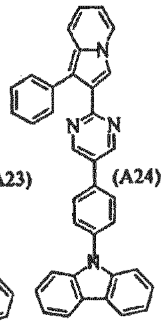
(A24)

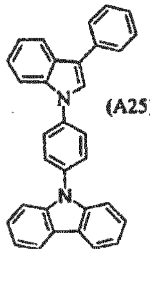
(A25)

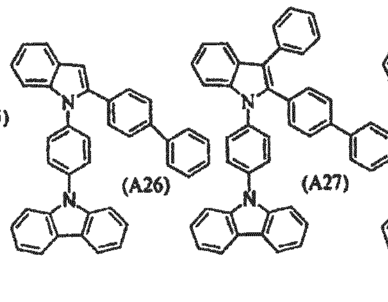
(A26) (A27)

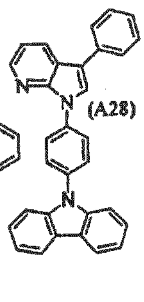
(A28)

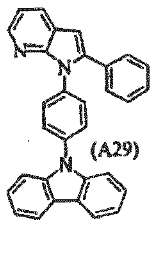
(A29)

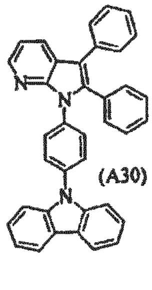
(A30)

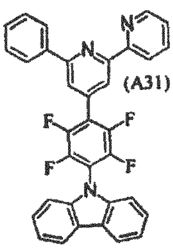
(A31)

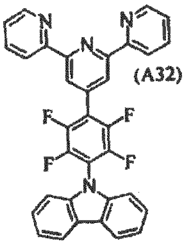
(A32)

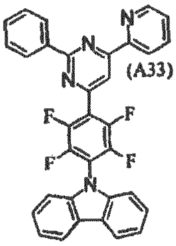
(A33)

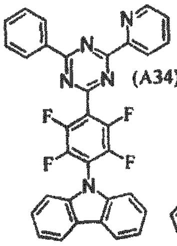
(A34)

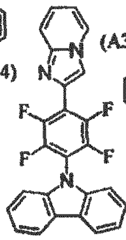
(A35)

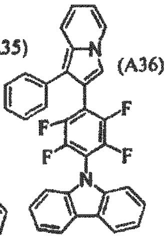
(A36)

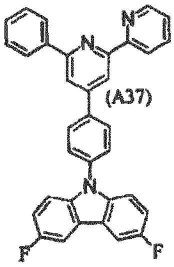
(A37)

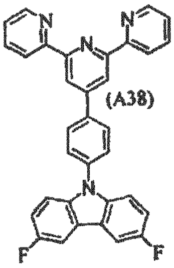
(A38)

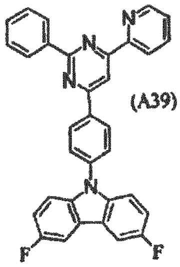
(A39)

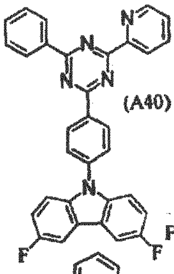
(A40)

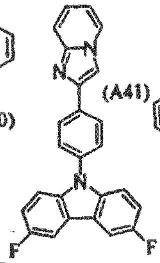
(A41)

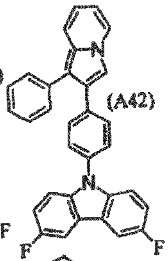
(A42)

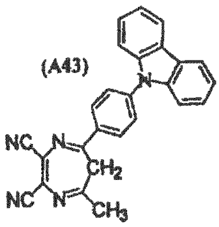
(A43)

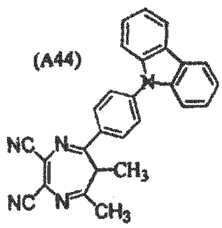
(A44)

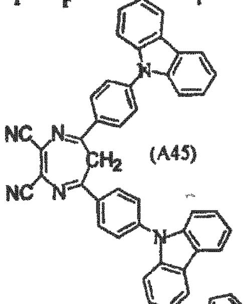
(A45)

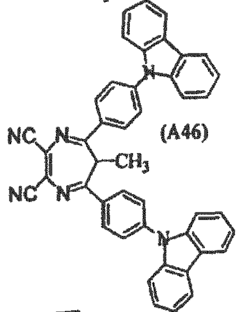
(A46)

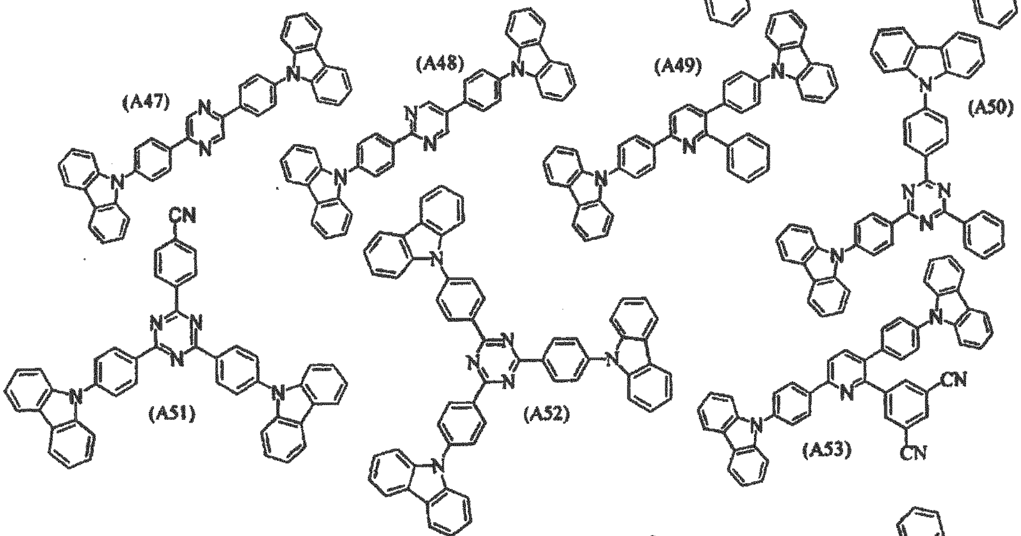
(A47) (A48) (A49) (A50) (A51) (A52) (A53)

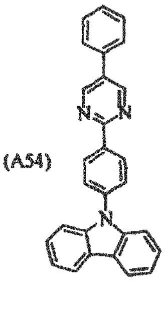
(A54)

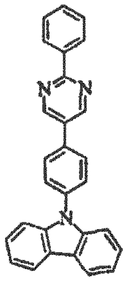
(A55)

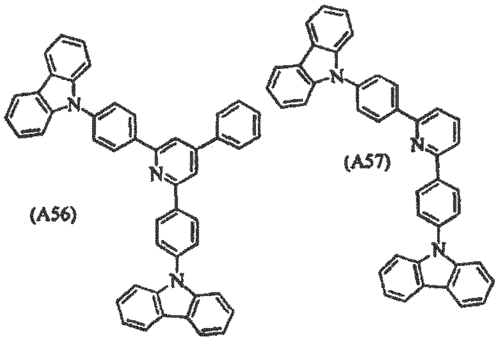
(A56) (A57)

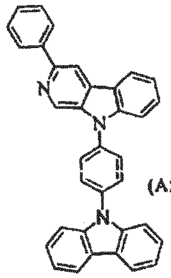
(A58)

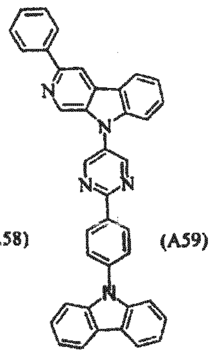
(A59)

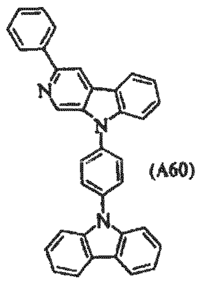
(A60)

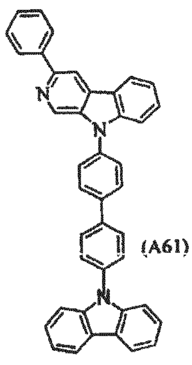
(A61)

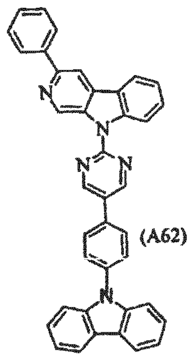
(A62)

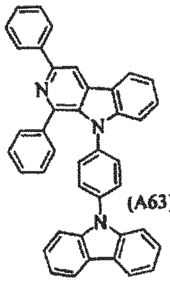
(A63)

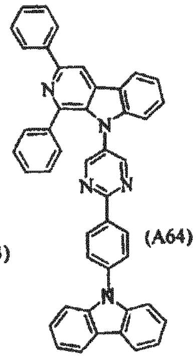
(A64)

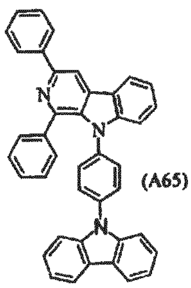
(A65)

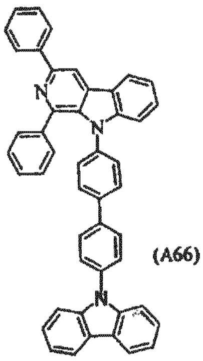
(A66)

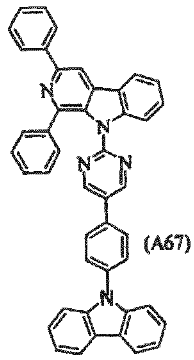
(A67)

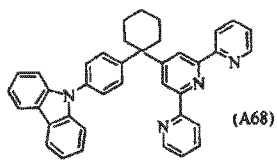
(A68)

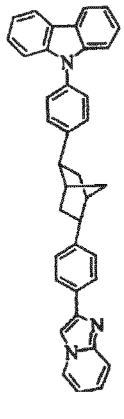
(A69)

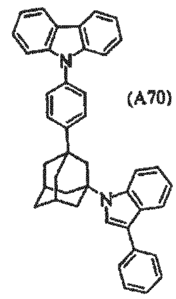
(A70)

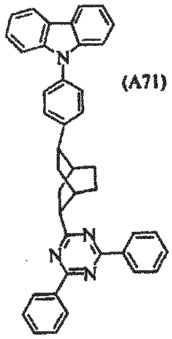
(A71)

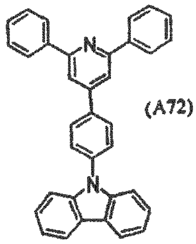
(A72)

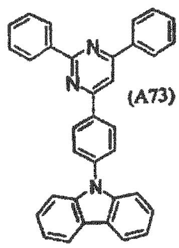
(A73)

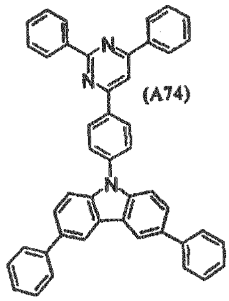
(A74)

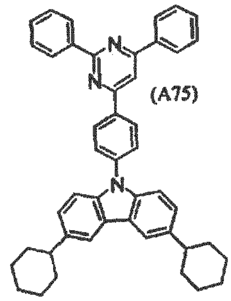
(A75)

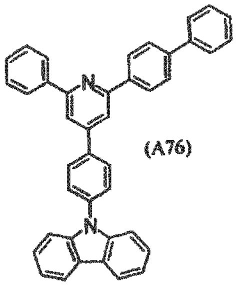
(A76)

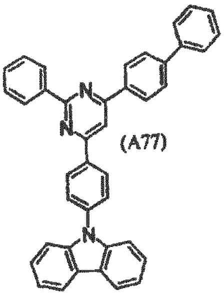
(A77)

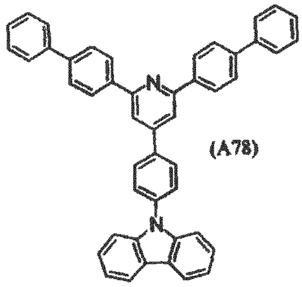
(A78)

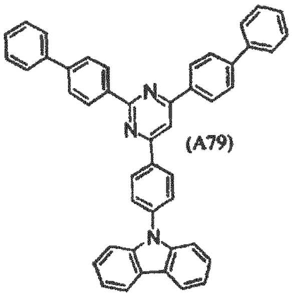
(A79)

(A80)
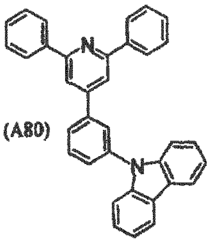

(A81)
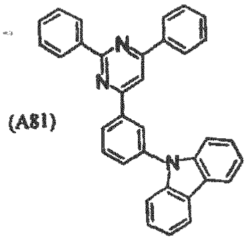

(A82)
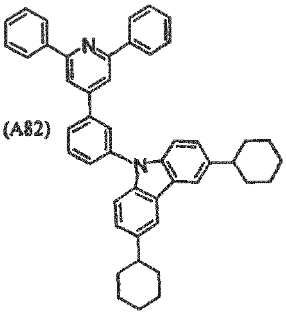

(A83)
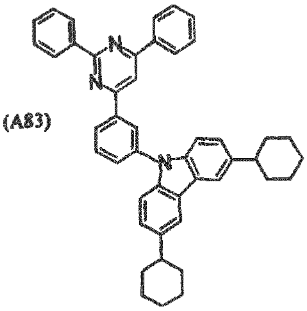

(A84)
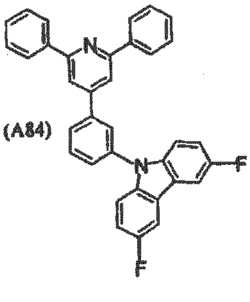

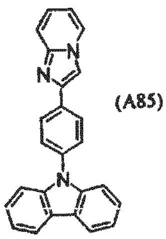
(A85)

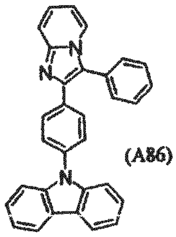
(A86)

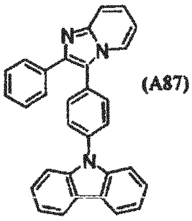
(A87)

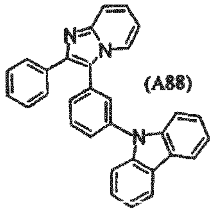
(A88)

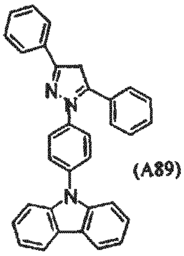
(A89)

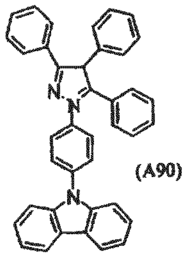
(A90)

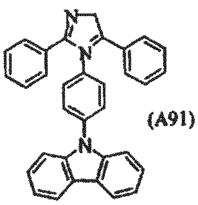
(A91)

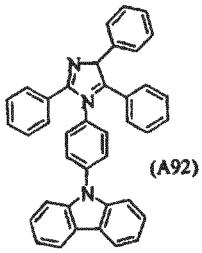
(A92)

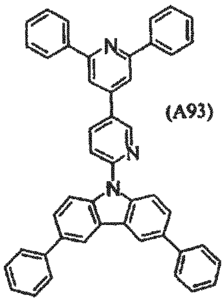
(A93)

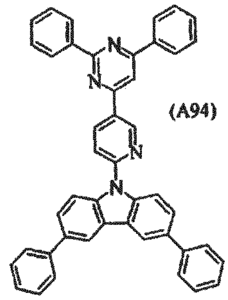
(A94)

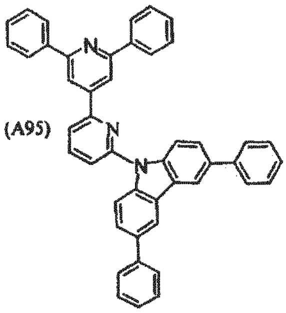
(A95)

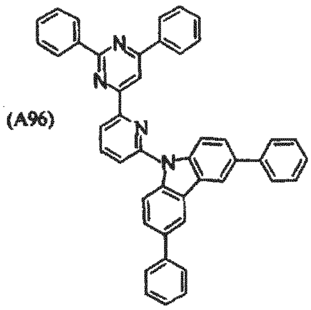
(A96)

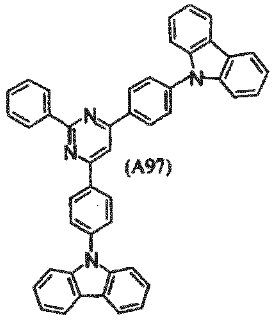
(A97)

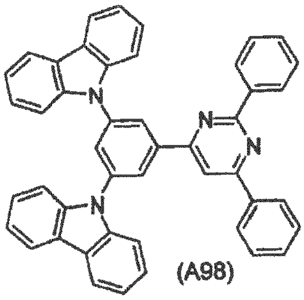
(A98)

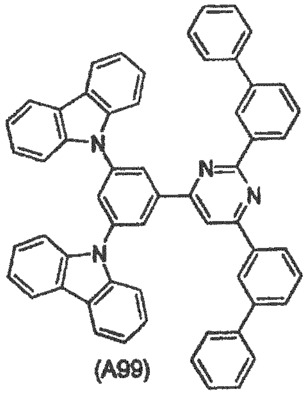
(A99)

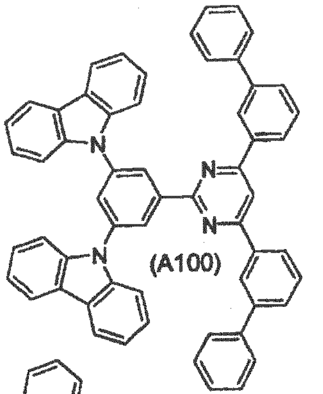
(A100)

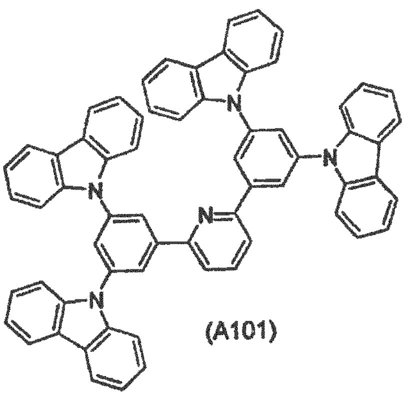
(A101)

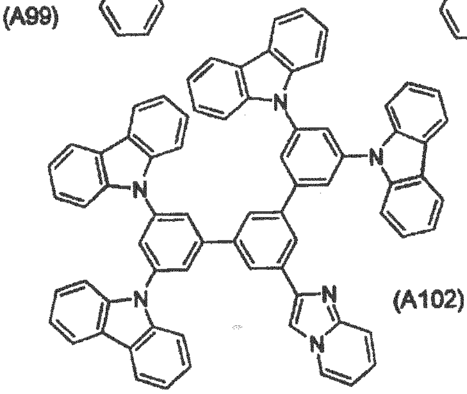
(A102)

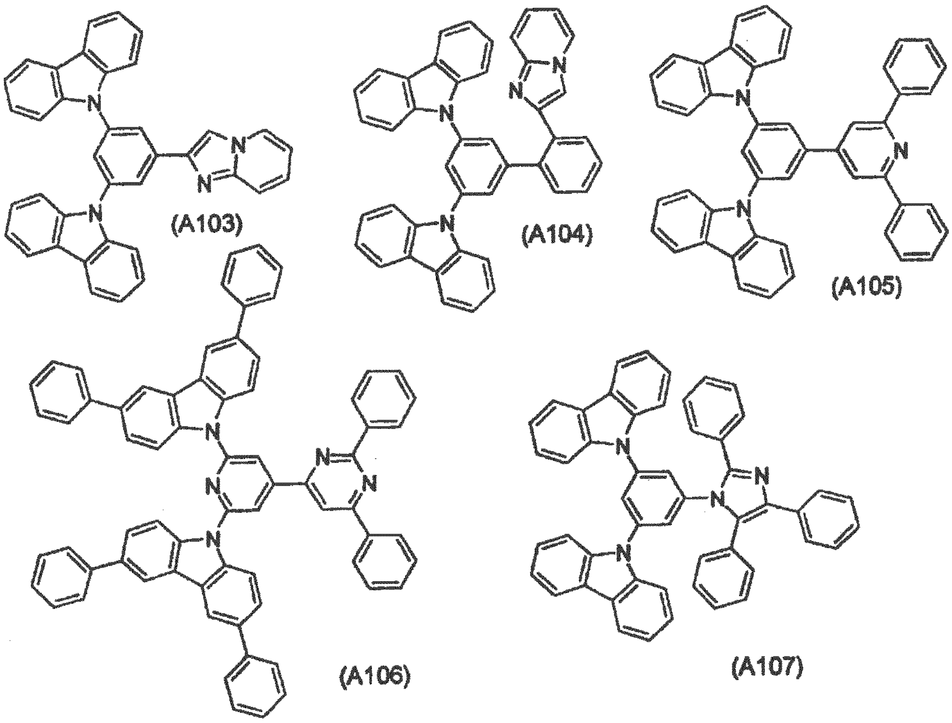

(A103) (A104) (A105)

(A106) (A107)

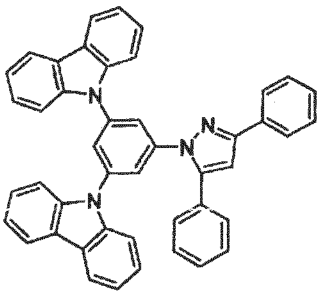

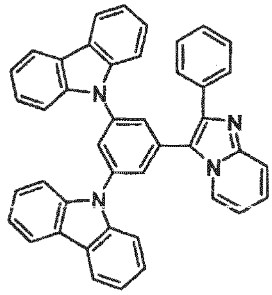

(A108) (A109)

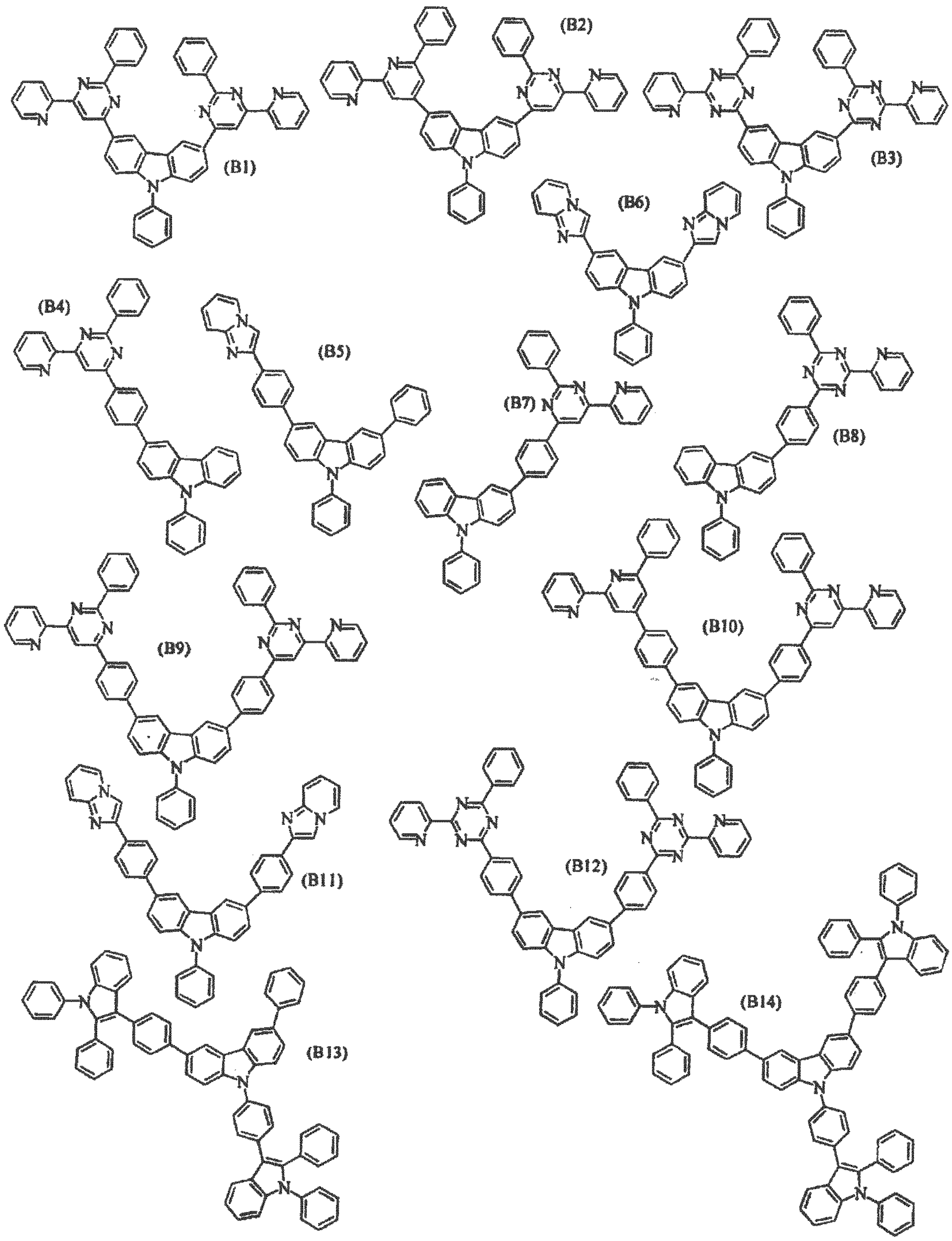

(B1) (B2) (B3) (B6) (B4) (B5) (B7) (B8) (B9) (B10) (B11) (B12) (B13) (B14)

In the invention, any of the electron-transporting materials listed above may be used as the host material for the emitting layer.

As examples of the configuration of the organic EL device according to the invention, the following configurations (a) to (c) can be given.

(a) Anode/emitting layer/electron-transporting layer/cathode
(b) Anode/hole-transporting layer/emitting layer/electron-transporting layer/cathode
(c) Anode/hole-injecting layer/hole-transporting layer/emitting layer/electron-transporting layer/cathode

The emitting layer in the organic EL device according to the invention is a layer obtained by adding a luminescent dopant to the above-described host material. The concentration of the luminescent dopant added to the host material is not particularly limited. The concentration of the luminescent dopant is preferably 0.1 to 20 wt%, and still more preferably 1 to 15 wt% from the viewpoint of current efficiency and drive voltage adjustment.

The organic EL device according to the invention is preferably supported by a substrate. The layers may be stacked on the substrate in the order from the anode to the cathode, or may be stacked on the substrate in the order from the cathode to the anode.

It is preferable that at least one of the anode and the cathode be formed of a transparent or translucent substance in order to efficiently outcouple light from the emitting layer.

The material for the substrate used in the invention is not particularly limited. A known material used for an organic EL device such as glass, transparent plastic, or quartz may be used.

As the material for the anode used in the invention, a metal, alloy, or electric conductive compound having a work function as large as 4 eV or more, or a mixture of these materials is preferably used. As specific examples of such a material, metals such as Au and dielectric transparent materials such as CuI, ITO, $SnO_2$, and ZnO can be given.

The anode may be formed by forming a thin film of the above-mentioned material by deposition, sputtering method, or the like.

When outcoupling light from the emitting layer through the anode, it is preferable that the anode have a transparency of more than 10%.

The sheet resistance of the anode is preferably several hundreds ohm/square or less.

The thickness of the anode is usually 10 nm to 1 micron, and preferably 10 to 200 nm, although the thickness varies depending on the material.

As the material for the cathode used in the invention, a metal, alloy, or electric conductive compound having a work function as small as 4 eV or less, or a mixture of these materials is preferably used. As specific examples of such a material, sodium, lithium, aluminum, magnesium/silver mixture, magnesium/copper mixture, $Al/Al_2O_3$, indium, and the like can be given.

The cathode may be formed by forming a thin film of the above-mentioned material by deposition, sputtering method, or the like.

When outcoupling light from the emitting layer through the cathode, it is preferable that the cathode have a transparency of more than 10%.

The sheet resistance of the cathode is preferably several hundreds ohm/square or less.

The thickness of the cathode is usually 10 nm to 1 micron, and preferably 50 to 200 nm, although the thickness varies depending on the material.

In the organic EL device according to the invention, a hole-injecting layer, a hole-transporting layer, an electron-injecting layer, and the like may be provided, as required, in order to further increase the current (or luminous) efficiency. The materials for these layers are not particularly limited. A known organic material for an organic EL may be used. As specific examples of such a material, amine derivatives, stilbene derivatives, silazane derivatives, polysilane, aniline copolymers, and the like can be given.

In the invention, it is preferable to add an inorganic material to the hole-injecting layer, the hole-transporting layer, and the electron-injecting layer. As examples of the inorganic material, metal oxides and the like can be given.

An inorganic material may be used between the electron-transporting layer and the cathode in order to increase the current (or luminous) efficiency. As specific examples of the inorganic material, fluorides and oxides of alkali metals such as Li, Mg, and Cs can be given.

The method of fabricating the organic EL device according to the invention is not particularly limited. The organic EL device according to the invention may be fabricated using a fabrication method used for a known organic EL device. In more detail, each layer may be formed by vacuum deposition, casting, coating, spin coating, or the like. Each layer may be formed by casting, coating, or spin coating using a solution prepared by dispersing an organic material for each layer in a transparent polymer such as polycarbonate, polyurethane, polystyrene, polyallylate, or polyester, or each layer may be formed by simultaneous deposition of an organic material and a transparent polymer.

EXAMPLES

The invention is described below in more detail by way of examples.

Compounds used in the examples were produced by the methods disclosed in JP-A-10-237438, Japanese Patent Application Nos. 2003-042625, 2002-071398, 2002-081234, 2002-299814, 2002-360134, 2002-071397, 2002-080817, 2002-083866, 2002-087560, and 2002-305375.

The parameters shown in the tables were measured by the following methods.

(1) Ionization potential (Ip)

Light (excitation light) from a deuterium lamp dispersed by a monochromator was irradiated to a material, and the resulting photoelectric emission was measured using an electrometer. The ionization potential was determined by calculating the photoelectric emission threshold value from the photoelectric emission photon energy curve obtained

using an extrapolation method. As the measuring instrument, an atmosphere ultraviolet photoelectron spectrometer "AC-1" (manufactured by Riken Keiki Co., Ltd.) was used.

(2) Optical energy gap (Eg)

Light of which the wavelength was resolved was irradiated to a toluene diluted solution of each material, and the optical energy gap was determined by conversion from the maximum wavelength of the absorption spectrum. As the measuring instrument, a spectrophotometer ("U-3400" manufactured by Hitachi, Ltd.) was used.

(3) Triplet energy gap ($Eg^T$)

The triplet energy gap ($Eg^T$ (Dopant)) was determined by the following method. An organic material was measured by a known phosphorescence measurement method (e.g. method described in "The World of Photochemistry" (edited by The Chemical Society of Japan, 1993), page 50). In more detail, an organic material was dissolved in a solvent (sample 10 micromol/l, EPA (diethyl ether:isopentane:ethanol = 5:5:2 (volume ratio), each solvent was spectrum grade) to obtain a phosphorescence measurement sample. After cooling the sample placed in a quartz cell to 77K, excitation light was irradiated to the sample, and the resulting phosphorescence was measured with respect to the wavelength. A tangent was drawn to the rise of the phosphorescence spectrum on the shorter wavelength side, and the value obtained by converting the wavelength into the energy value was taken as the triplet energy gap ($Eg^T$). The triplet energy gap was measured using a "F-4500" fluorescence spectrophotometer (manufactured by Hitachi, Ltd.) and optional low temperature measurement equipment. Note that the measuring instrument is not limited thereto. The triplet energy gap may be measured by combining a cooling device, a low temperature container, an excitation light source, and a light receiving device.

In the examples, the wavelength was converted using the following expression.

$$Eg^T\ (eV) = 1239.85/\lambda_{edge}$$

The meaning of "$\lambda_{edge}$" is as follows. When the phosphorescence spectrum is expressed in which the vertical axis indicates the phosphorescence intensity and the horizontal axis indicates the wavelength, and a tangent is drawn to the rise of the phosphorescence spectrum on the shorter wavelength side, "$\lambda_{edge}$" is the wavelength at the intersection of the tangent and the horizontal axis. The unit for "$\lambda_{edge}$" is nm.

Examples 1 to 5

An organic EL device shown in Fig. 1 was fabricated as follows.

A glass substrate 11 (manufactured by Geomatics Co.), measuring 25 mm x 75 mm x 1.1 mm thick, with an ITO transparent electrode (anode) 12 was subjected to ultrasonic cleaning in isopropyl alcohol for 5 minutes and then to UV ozone cleaning for 30 minutes . The cleaned glass substrate 11 with transparent electrode lines was mounted on a substrate holder in a vacuum deposition device. First, a 100 nm thick film of N,N'-bis(N,N'-diphenyl-4-aminophenyl)-N,N-diphenyl-4,4'-diamino-1,1'-biphenyl (hereinafter referred to as TPD 232 film) 13 was formed by resistance heating deposition on the surface where the transparent electrode lines were formed so as to cover the transparent electrode 12. This TPD 232 film 13 functioned as a hole-injecting layer (a hole-transporting layer).

After the formation of the TPD 232 film 13, a 10 nm thick hole-transporting layer (hereinafter referred to as HTM) 14 was formed by resistance heating deposition. After the formation of the hole-transporting layer 14, a host compound (Host No. 1, Ip=5. 6 eV, Eg=3. 53 eV, $Eg^T$=2. 85 eV) and a luminescent dopant (FIrpic, Eg=2.8 eV, $Eg^T$=2.7 eV) were co-deposited by resistance heating to form a 30 nm thick film 15 thereon. The concentration of FIrpic was 7.5 wt%. This Host No.1: FIrpic film 15 functioned as an emitting layer.

After the formation of the emitting layer 15, a 30 nm thick electron-transporting layer 16 was formed by resistance heating deposition on the emitting layer using electron-transporting materials shown in Table 1 (ETM_No.1 (Example 1), ETM_No.2 (Example 2), ETM_No.3 (Example 3) PC-7 (Example 4*) and 8-hydroxyquinolinol aluminum complex (Alq) (Example 5*)) (*: not according to the invention).

Thereafter, a 0.1 nm thick electron-transporting electrode (cathode) 17 was formed of LiF at a film-formation rate of 1 Å/minute. A metal Al was deposited on the LiF layer 17 to form a 130 nm thick metal cathode 18, thereby fabricating an organic EL device 100.

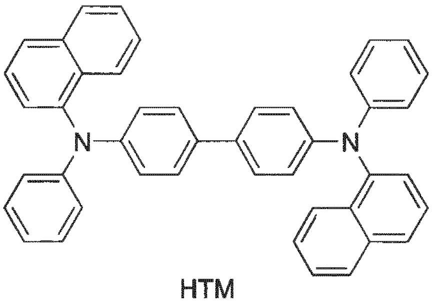

HTM

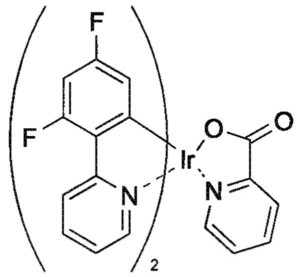

FIrpic

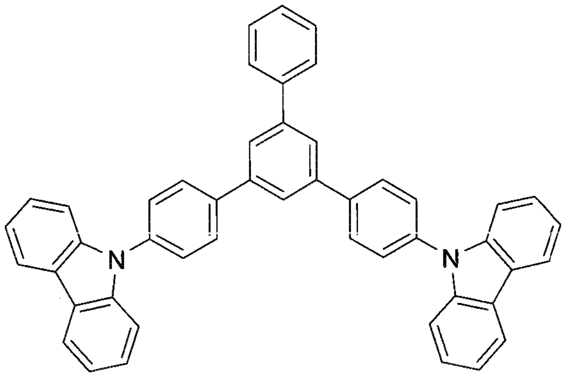

Host No.1

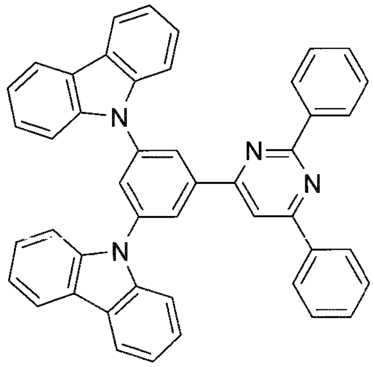

ETM_No.1

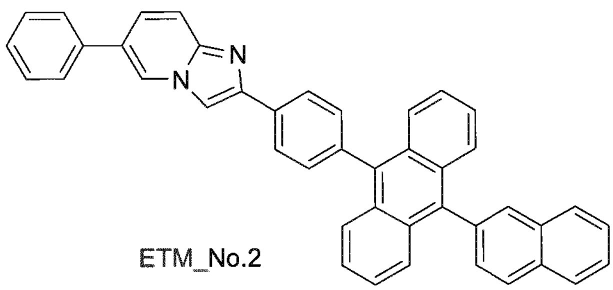

ETM_No.2

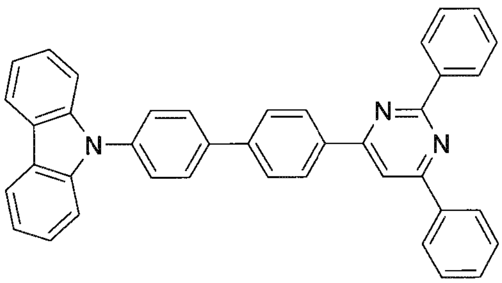

ETM_No.3

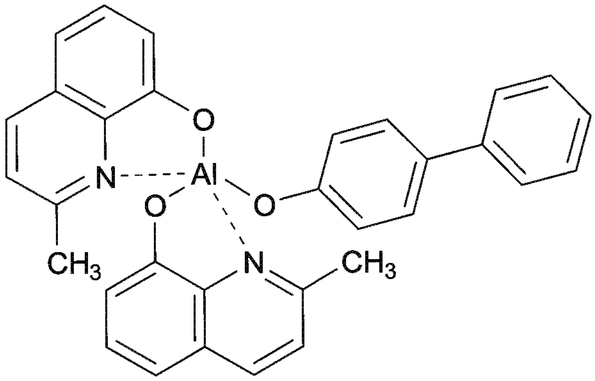

PC-7

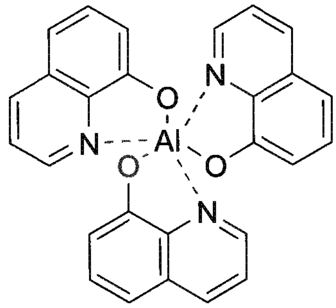

Alq

(PC-7 not according to the invention)

Comparative example 1

An organic EL device of the same structure was fabricated in the same manner as in Example 1 using the following compound as an electron-transporting material.

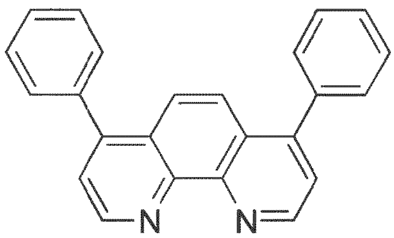

ETM_ref

(Evaluation of organic EL device)

Luminance, efficiency and chromaticity of the organic EL devices obtained in the examples and the comparative example were measured in the condition of applying a certain DC voltage to calculate a current efficiency (=(luminance)/(current density)) at a luminance of about 100 cd/m$^2$. The results were shown in Table 1.

Table 1

| | Electron-transporting element | | | | Voltage (V) | Current density (mA/cm$^2$) | CIE-(x, y) | Current efficiency (cd/A) |
|---|---|---|---|---|---|---|---|---|
| | Type | Ip (eV) | Eg (eV) | Eg$^T$ (eV) | | | | |
| Example 1 | ETM_No.1 | 5.7 | 3.5 | 2.90 | 6.0 | 0.83 | (0.20, 0.41) | 12.0 |
| Example 2 | ETM_No.2 | 5.7 | 3.0 | 2.80 | 7.5 | 0.58 | (0.21, 0.41) | 17.0 |
| Example 3 | ETM_No.3 | 5.8 | 3.3 | 2.60 | 6.0 | 0.83 | (0.21, 0.41) | 12.0 |
| Example 4* | PC-7 | 5.7 | 3.0 | less than 3.0 | 7.5 | 0.91 | (0.21, 0.41) | 11.0 |

(continued)

| | Electron-transporting element | | | | Voltage (V) | Current density ($mA/cm^2$) | CIE-(x, y) | Current efficiency (cd/A) |
|---|---|---|---|---|---|---|---|---|
| | Type | Ip (eV) | Eg (eV) | $Eg^T$ (eV) | | | | |
| Example 5* | Alq | 5.7 | 2.7 | less than 2.7 | 8.0 | 1.01 | (0.21, 0.41) | 10.0 |
| Comparative Example 1 | ETM_ref | 6.6 | 4.4 | 2.6 | 9.5 | 2.10 | (0.21, 0.41) | 4.9 |
| Emitting layer: Host material (Host No.1); Ip=5.6eV, Eg=3.53eV, $Eg^T$=2.85eV Luminescent dopant (FIrpic); Eg=2.8eV, $Eg^T$=2.7eV<br>* Not according to the invention | | | | | | | | |

Table 1 shows that the L/J efficiency decreased in Comparative example compared with Examples since ΔIp was large (ΔIp=1 eV). A signal of hole's moving could not be measured by the Time of Flight method for the deposited film of the compound used in Comparative example. These results reveal that the invention realizes a device with a higher current efficiency than conventional devices which have the same emission color.

Examples 6 and 7

A glass substrate, measuring 25 mm x 75 mm x 1.1 mm thick, with ITO transparent electrode lines (manufactured by Geomatics Co.) was subjected to ultrasonic cleaning in isopropyl alcohol for 5 minutes and then to UV ozone cleaning for 30 minutes. The cleaned glass substrate with transparent electrode lines was mounted on a substrate holder in a vacuum deposition device. First, a 100 nm thick TPD 232 film was formed by resistance heating deposition on the surface where the transparent electrode lines were formed so as to cover the transparent electrode. The TPD 232 film functioned as a hole-injecting (hole-transporting) layer.

After the formation of the TPD 232 film, a 10 nm thick hole-transporting layer (HTM) was formed by resistance heating deposition. After the formation of the hole-transporting layer, a host material (Host No. 1) and a luminescent dopant (FIrpic) were co-deposited by resistance heating to form a 30 nm thick film thereon. The concentration of FIrpic was 7.5 wt%. This Host No. 1:FIrpic film functioned as an emitting layer.

After the formation of the emitting layer, a 20 nm thick electron-transporting layer was formed by resistance heating deposition on the emitting layer using electron-transporting materials; ETM_No. 1 (Example 6) and ETM_No. 3 (Example 7).

A 10 nm thick Alq film was further formed to form an electron-transporting layer.

Thereafter, a 0.1 nm thick electron-transporting electrode (cathode) was formed of LiF at a film-formation rate of 1 Å/minute. A metal Al was deposited on the LiF layer to form a 130 nm thick metal cathode, thereby fabricating an organic EL device. The device was evaluated. The results are shown in Table 2.

Example 8

An organic EL device of the same structure was fabricated in the same manner as in Example 6 except that ETM_No. 3 was used instead of Alq in Example 6. The results are shown in Table 2.

Example 9

The same steps as in Example 7 were repeated until the formation of the ETM_No. 3 film and then a 10 nm thick Alq film was formed.

Thereafter, a 0.1 nm thick electron-transporting electrode (cathode) was formed of LiF at a film-formation rate of 1 Å/minute. A metal Al was deposited on the LiF layer to form a 130 nm thick metal cathode, thereby fabricating an organic EL device. The evaluation results are shown in Table 2.

Table 2

| | Electron-transporting material | | | | Voltage (V) | Current density ($mA/cm^2$) | CIE-(x, y) | Current efficiency (cd/A) |
|---|---|---|---|---|---|---|---|---|
| | Type*) | Ip (eV) | Eg (eV) | $Eg^T$ (eV) | | | | |
| Example 6 | Alq | 5.7 | 2.7 | < 2.7 | 6.2 | 0.29 | (0.18, 0.40) | 35 |
| | ETM_No.1 | 5.7 | 3.5 | 2.90 | | | | |
| Example 7 | Alq | 5.7 | 2.7 | < 2.7 | 6.5 | 0.29 | (0.18, 0.40) | 36 |
| | ETM_No.3 | 5.8 | 3.3 | 2.60 | | | | |
| Example 8 | ETM_No.3 | 5.8 | 3.3 | 2.60 | 6.0 | 0.29 | (0.18, 0.40) | 37 |
| | ETM_No.1 | 5.7 | 3.5 | 2.90 | | | | |
| Example 9 | Alq | 5.7 | 2.7 | < 2.7 | 6.0 | 0.29 | (0.18, 0.40) | 37 |
| | ETM_No.3 | 5.8 | 3.3 | 2.60 | | | | |
| | ETM_No.1 | 5.7 | 3.5 | 2.90 | | | | |

*) The upper material constitutes the electron-transporting layer on the metal electrode side. The lower material constitutes the electron-transporting layer contacting the emitting layer.
Emitting layer: Host material (Host No.1); Ip=5.6eV, Eg=3.53eV, $Eg^T$=2.85eV Luminescent dopant (FIrpic); Eg=2.8eV, $Eg^T$=2.7eV

The results revealed that the invention realizes a device with a higher current efficiency than conventional devices which have the same emission color.

Examples 10 to 18

An organic EL device of the same structure was fabricated in the same manner as in Example 6 except that Etm_No. 4 to ETM_No. 12 shown below were used instead of ETM_No. 1 in Example 6. The evaluation results are shown in Table 3.

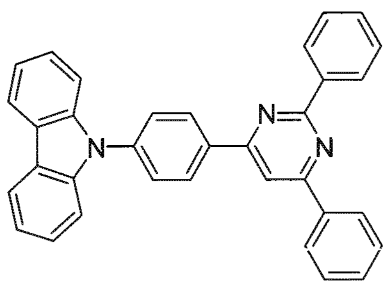

ETM_No.4

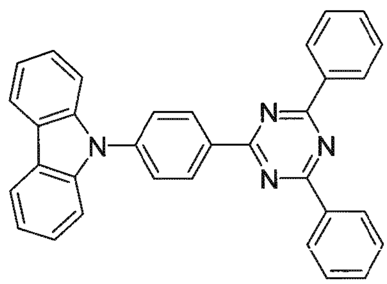

ETM_No.5

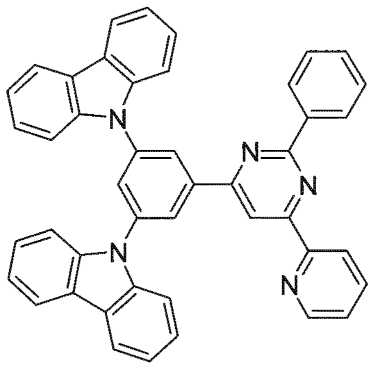

ETM_No.6

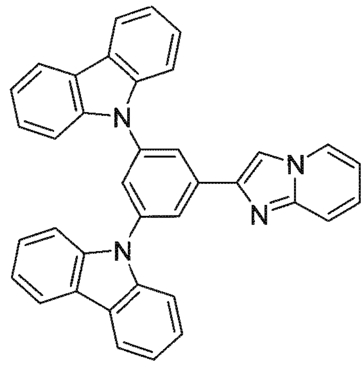

ETM_No.7

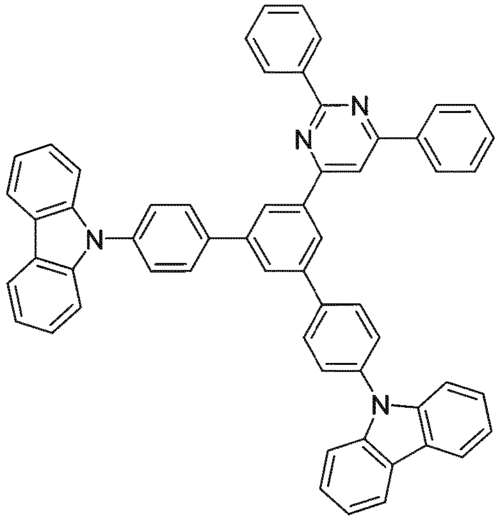

ETM_No.8

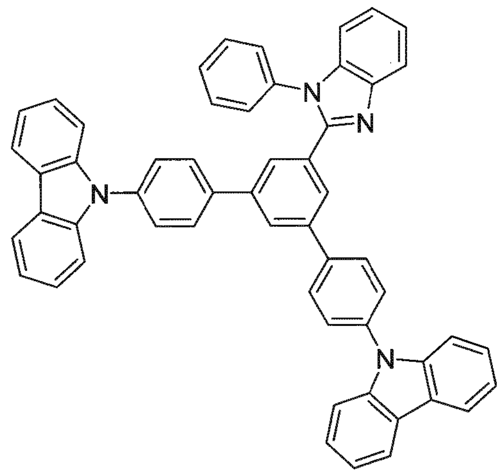

ETM_No.9

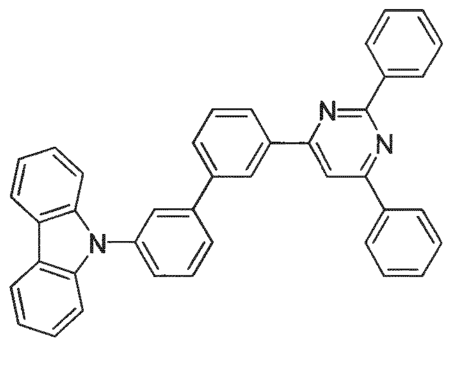

ETM_No.10

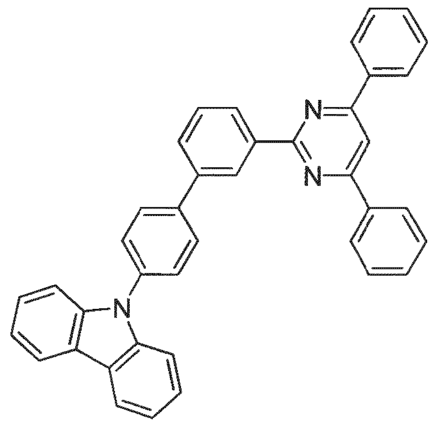

ETM_No.11

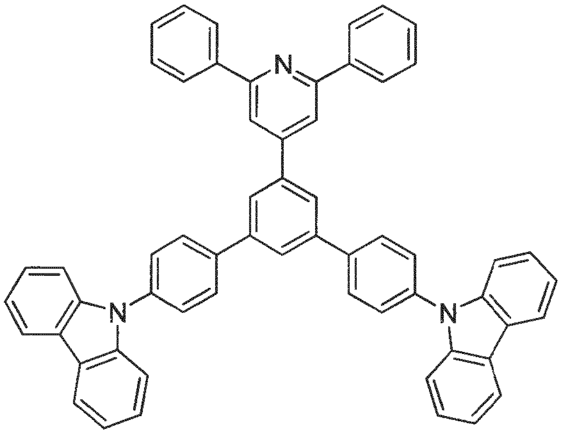

ETM_No.12

Table 3

| Example | Compound | Energy gap | | Ip (eV) | Af (=Ip-Eg) (eV) | Voltage (V) | Current density (mA/ $cm^2$) | Luminance (nit) | chromaticity | | Current efficiency (cd/A) |
|---|---|---|---|---|---|---|---|---|---|---|---|
| | | Eg (eV) | $Eg^T$ (eV) | | | | | | x | y | |
| 10 | ETM_No.4 | 3.2 | 2.8 | 5.6 | 2.4 | 8.28 | 1.93 | 462 | 0.171 | 0.411 | 23.9 |
| 11 | ETM_No.5 | 3.1 | 2.8 | 5.6 | 2.5 | 7.47 | 2.01 | 447 | 0.168 | 0.389 | 22.3 |
| 12 | ETM_No.6 | 3.55 | 2.9 | 5.4 | 1.9 | 8.18 | 2.02 | 486 | 0.174 | 0.428 | 24.1 |
| 13 | ETM_No.7 | 3.44 | 2.8 | 5.5 | 2.1 | 7.89 | 0.69 | 115 | 0.174 | 0.404 | 16.7 |
| 14 | ETM_No.8 | 3.89 | 2.9 | 5.8 | 1.9 | 6.68 | 0.30 | 100 | 0.178 | 0.434 | 32.9 |
| 15 | ETM_No.9 | 3.5 | 2.8 | 5.5 | 2.0 | 7.96 | 0.88 | 101 | 0.173 | 0.404 | 11.5 |
| 16 | ETM_No.10 | 3.55 | 2.9 | 5.73 | 2.18 | 7.71 | 0.30 | 102 | 0.176 | 0.431 | 34.1 |
| 17 | ETM_No.11 | 3.53 | 2.88 | 5.8 | 2.2 | 7.35 | 0.58 | 101 | 0.173 | 0.419 | 17.4 |
| 18 | ETM_No.12 | 3.52 | 2.83 | 6.0 | 2.5 | 9.20 | 0.75 | 99 | 0.175 | 0.424 | 13.2 |

Industrial Applicability

The organic EL device of the invention can be used for an information display device, a display device for automobiles, a lighting and so on because its luminous efficiency is high at a high luminance and the electric power consumption is low. Specifically, it can be suitably used for a flat luminescent body for wall hanging TVs, a back lighting source for displays and so on.

## Claims

1. An organic electroluminescent device (100) having a multilayer structure comprising at least an emitting layer (15) and one or more electron-transporting layer(s) (16) between a cathode (17,18) and an anode (12);
the triplet energy gap ($Eg^T$) of a host material forming the emitting layer (15) being 2.52 eV or more and 3.7 eV or less;
an electron-transporting material forming the electron-transporting layer (16) which contacts the emitting layer (15) being different from the host material, and having a hole mobility measured by the time of flight method ($\mu$(h)) > 1.0 x $10^{-7}$ $cm^2$ / (V•s) at a field intensity of $10^5$ to $10^7$ V/cm, and
the emitting layer (15) comprising a phosphorescent metal complex compound containing a heavy metal,
wherein the electron-transporting material forming the electron-transporting layer (16) which contacts the emitting layer (15) has one or more of the following structures (1) to (3):
five-membered ring or six-membered ring containing =N- skeleton (1),

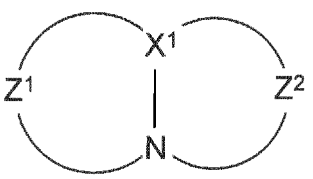

(2)

wherein $X^1$ is a carbon atom or a nitrogen atom, and $Z^1$ and $Z^2$ are independently atom groups which can form a nitrogen-containing hetero ring,

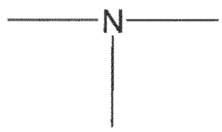

(3)

2. The organic electroluminescent device (100) according to claim 1, wherein the ionization potential (Ip) of the electron-transporting material forming the electron-transporting layer (16) which contacts the emitting layer (15) is 5.6 eV or more and less than 6.0 eV.

3. The organic electroluminescent device (100) according to claim 1, wherein the electron-transporting material forming the electron-transporting layer (16) which contacts the emitting layer (15) has a nitrogen-containing aromatic polycyclic group containing a five-membered ring or six-membered ring, and when the group contains a plurality of nitrogen atoms, the organic compound has a skeleton containing the nitrogen atoms in non-adjacent bonding positions.

4. The organic electroluminescent device (100) according to claim 1, wherein the electron-transporting material forming the electron-transporting layer (16) which contacts the emitting layer (15) or the host material is a compound having one carbazolyl group or tetrahydrocarbazolyl group.

5. The organic electroluminescent device (100) according to claim 1, wherein the electron-transporting material forming the electron-transporting layer (16) which contacts the emitting layer (15) or the host material is a compound having two carbazolyl groups or tetrahydrocarbazolyl groups.

6. The organic electroluminescent device (100) according to claim 1, wherein the electron-transporting material forming the electron-transporting layer (16) which contacts the emitting layer (15) or the host material is a compound having a carbazolyl group or a tetrahydrocarbazolyl group, and a nitrogen-containing hetero ring group.

**7.** The organic electroluminescent device (100) according to claim 1, wherein a difference ($\Delta Ip$ = Ip (electron-transporting material) - Ip (host material)) in ionization potential between the host material forming the emitting layer (15) and the electron-transporting material forming the electron-transporting layer (16) which contacts the emitting layer (15) is -0.2 eV < $\Delta Ip$ < 0.4 eV.

**8.** The organic electroluminescent device (100) according to claim 1, having a plurality of electron-transporting layers (16).

**9.** The organic electroluminescent device (100) according to claim 8, wherein a difference ($\Delta Ip'$), represented by the following expression, in ionization potential between electron-transporting materials forming two adjacent layers of the plurality of electron-transporting layers (16) is -0.2 eV < $\Delta Ip'$ < 0.4 eV,

$$\Delta Ip' = Ip\ (i) - Ip\ (i+1)$$

wherein Ip (i) is the ionization potential of an electron-transporting material forming an i-th electron-transporting layer (16) from the emitting layer (15), is an integer of 1 or more and (N-1) or less, and N is the number of the electron-transporting layers (16).

**10.** The organic electroluminescent device (100) according to claim 8, wherein the optical energy gap (Eg) of an electron-transporting material forming an electron-transporting layer (16) is equal to or smaller than the optical energy gap (Eg) of an electron-transporting material forming the adjacent electron-transporting layer (16) nearer to the emitting layer (15).

**11.** The organic electroluminescent device (100) according to claim 8, wherein the triplet energy gap of an electron-transporting material forming an electron-transporting layer (16) is equal to or smaller than the triplet energy gap of an electron-transporting material forming the adjacent electron-transporting layer (16) nearer to the emitting layer (15).

**12.** The organic electroluminescent device (100) according to claim 1, wherein the triplet energy gap of the electron-transporting material forming the electron-transporting layer (16) contacting the emitting layer (15) is larger than the triplet energy gap of the metal complex compound of the emitting layer (15).

## Patentansprüche

**1.** Organische Elektrolumineszenzvorrichtung (100) mit einer mehrschichtigen Struktur, umfassend mindestens eine emittierende Schicht (15) und eine oder mehrere Elektronentransportschicht(en) (16) zwischen einer Kathode (17, 18) und einer Anode (12);
wobei die Triplettenergielücke ($Eg^T$) eines Hostmaterials, das die emittierende Schicht (15) bildet, 2,52 eV oder mehr und 3,7 eV oder weniger ist;
ein Elektronentransportmaterial, das die Elektronentransportschicht (16) bildet, die mit der emittierenden Schicht (15) in Kontakt steht, sich von dem Hostmaterial unterscheidet und eine Lochmobilität, gemessen durch das Flugzeitverfahren ($\mu$(h)), > 1,0 $\times$ $10^{-7}$ $cm^2/(V.s)$ bei einer Feldintensität von $10^5$ bis $10^7$ V/cm ist und
die emittierende Schicht (15) eine phosphoreszierende Metallkomplexverbindung umfasst, die ein Schwermetall enthält,
wobei das Elektronentransportmaterial, das die Elektronentransportschicht (16) bildet, die mit der emittierenden Schicht (15) in Kontakt steht, eine oder mehrere der folgenden Strukturen (1) bis (3) aufweist:
fünfgliedrigen Ring oder sechsgliedrigen Ring, enthaltend =N- Skelett (1),

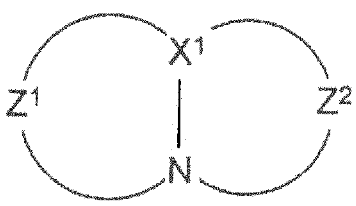

(2)

wobei $X^1$ ein Kohlenstoffatom oder ein Stickstoffatom ist und $Z^1$ und $Z^2$ unabhängig Atomgruppen sind, die einen stickstoffhaltigen Heteroring bilden können,

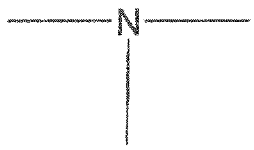

(3).

2. Organische Elektrolumineszenzvorrichtung (100) nach Anspruch 1, wobei das Ionisationspotential (Ip) des Elektronentransportmaterials, das die Elektronentransportschicht (16) bildet, die mit der emittierenden Schicht (15) in Kontakt steht, 5,6 eV oder mehr und weniger als 6,0 eV ist.

3. Organische Elektrolumineszenzvorrichtung (100) nach Anspruch 1, wobei das Elektronentransportmaterial, das die Elektronentransportschicht (16) bildet, die mit der emittierenden Schicht (15) in Kontakt steht, eine stickstoffhaltige, aromatische, polycyclische Gruppe hat, die einen fünfgliedrigen Ring oder sechsgliedrigen Ring enthält, und wenn die Gruppe eine Vielzahl von Stickstoffatomen enthält, die organische Verbindung ein Skelett hat, das die Stickstoffatome in nicht angrenzenden Bindungspositionen enthält.

4. Organische Elektrolumineszenzvorrichtung (100) nach Anspruch 1, wobei das Elektronentransportmaterial, das die Elektronentransportschicht (16) bildet, die mit der emittierenden Schicht (15) oder dem Hostmaterial in Kontakt steht, eine Verbindung mit einer Carbazolylgruppe oder Tetrahydrocarbazolylgruppe ist.

5. Organische Elektrolumineszenzvorrichtung (100) nach Anspruch 1, wobei das Elektronentransportmaterial, das die Elektronentransportschicht (16) bildet, die mit der emittierenden Schicht (15) oder dem Hostmaterial in Kontakt steht, eine Verbindung mit zwei Carbazolylgruppen oder Tetrahydrocarbazolylgruppen ist.

6. Organische Elektrolumineszenzvorrichtung (100) nach Anspruch 1, wobei das Elektronentransportmaterial, das die Elektronentransportschicht (16) bildet, die mit der emittierenden Schicht (15) oder dem Hostmaterial in Kontakt steht, eine Verbindung mit einer Carbazolylgruppe oder einer Tetrahydrocarbazolylgruppe und einer stickstoffhaltigen Heteroringgruppe ist.

7. Organische Elektrolumineszenzvorrichtung (100) nach Anspruch 1, wobei eine Differenz ($\Delta Ip = Ip$ (Elektronentransportmaterial) - $Ip$ (Hostmaterial)) im Ionisationspotential zwischen dem Hostmaterial, das die emittierende Schicht (15) bildet, und dem Elektronentransportmaterial, das die Elektronentransportschicht (16) bildet, die mit der emittierenden Schicht (15) in Kontakt steht, $-0{,}2\ eV < \Delta Ip < 0{,}4\ eV$ ist.

8. Organische Elektrolumineszenzvorrichtung (100) nach Anspruch 1 mit einer Vielzahl von Elektronentransportschichten.

9. Organische Elektrolumineszenzvorrichtung (100) nach Anspruch 8, wobei eine Differenz ($\Delta Ip'$), dargestellt durch den folgenden Ausdruck, im Ionisationspotential zwischen Elektronentransportmaterialien, die zwei benachbarte Schichten der Vielzahl von Elektronentransportschichten (16) bilden, , $-0{,}2\ eV < \Delta Ip' < 0{,}4\ eV$ ist.

$$\Delta Ip' = Ip\ (i) - Ip\ (i+1)$$

wobei Ip (i) das Ionisationspotential eines Elektronentransportmaterials ist, das eine i-te Elektronentransportschicht (16) von der emittierenden Schicht (15) bildet, eine ganze Zahl von 1 oder mehr und (N-1) oder weniger ist, und N die Anzahl der Elektronentransportschichten (16) ist.

10. Organische Elektrolumineszenzvorrichtung (100) nach Anspruch 8, wobei die optische Energielücke (Eg) eines Elektronentransportmaterials, das eine Elektronentransportschicht (16) bildet, gleich oder kleiner als die optische Energielücke (Eg) eines Elektronentransportmaterials ist, das die benachbarte Elektronentransportschicht (16) näher zur emittierenden Schicht (15) bildet.

11. Organische Elektrolumineszenzvorrichtung (100) nach Anspruch 8, wobei die Triplettenergielücke eines Elektronentransportmaterials, das eine Elektronentransportschicht (16) bildet, gleich oder kleiner als die Triplettenergielücke eines Elektronentransportmaterials ist, das die benachbarte Elektronentransportschicht (16) näher zu der emittierenden Schicht (15) bildet.

12. Organische Elektrolumineszenzvorrichtung (100) nach Anspruch 1, wobei die Triplettenergielücke des Elektronentransportmaterials, das die Elektronentransportschicht (16) bildet, die mit der emittierenden Schicht (15) in Kontakt steht, größer ist als die Triplettenergielücke der Metallkomplexverbindung der emittierenden Schicht (15).

## Revendications

1. Dispositif électroluminescent organique (100) ayant une structure multicouche comprenant au moins une couche émettrice (15) et une ou plusieurs couche(s) de transport d'électrons (16) entre une cathode (17, 18) et une anode (12) ;
la bande interdite de triplet ($Eg^T$) d'un matériau hôte formant la couche émettrice (15) étant de 2,52 eV ou plus et de 3,7 eV ou moins ;
un matériau de transport d'électrons formant la couche de transport d'électrons (16) qui est en contact avec la couche émettrice (15) étant différent du matériau hôte, et ayant une mobilité de trous mesurée par la méthode du temps de vol ($\mu$(h)) > 1,0 x $10^{-7}$ $cm^2$/ (V·s) à une intensité de champ de $10^5$ à $10^7$ V/cm, et
la couche émettrice (15) comprenant un composé complexe métallique phosphorescent contenant un métal lourd, dans lequel le matériau de transport d'électrons formant la couche de transport d'électrons (16) qui est en contact avec la couche émettrice (15) présente une ou plusieurs des structures suivantes (1) à (3) :
un cycle à cinq chaînons ou un cycle à six chaînons contenant un squelette =N- (1),

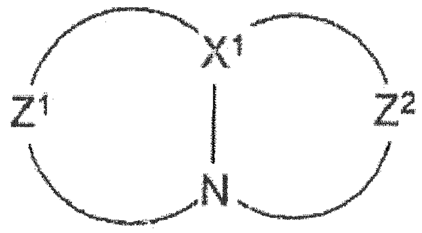

(2)

où $X^1$ est un atome de carbone ou un atome d'azote, et $Z^1$ et $Z^2$ sont indépendamment des groupes d'atomes qui peuvent former un hétérocycle contenant de l'azote,

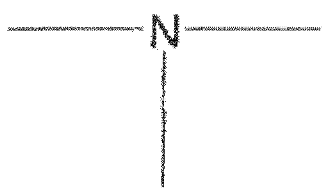

(3)

2. Dispositif électroluminescent organique (100) selon la revendication 1, dans lequel le potentiel d'ionisation (Ip) du matériau de transport d'électrons formant la couche de transport d'électrons (16) qui est en contact avec la couche émettrice (15) est de 5,6 eV ou plus et inférieur à 6,0 eV.

3. Dispositif électroluminescent organique (100) selon la revendication 1, dans lequel le matériau de transport d'électrons formant la couche de transport d'électrons (16) qui est en contact avec la couche émettrice (15) présente un groupe polycyclique aromatique contenant de l'azote contenant un cycle à cinq chaînons ou un cycle à six chaînons, et lorsque le groupe contient une pluralité d'atomes d'azote, le composé organique présente un squelette contenant les atomes d'azote dans des positions de liaison non adjacentes.

**4.** Dispositif électroluminescent organique (100) selon la revendication 1, dans lequel le matériau de transport d'électrons formant la couche de transport d'électrons (16) qui est en contact avec la couche émettrice (15) ou le matériau hôte est un composé ayant un groupe carbazolyle ou groupe tétrahydrocarbazolyle.

**5.** Dispositif électroluminescent organique (100) selon la revendication 1, dans lequel le matériau de transport d'électrons formant la couche de transport d'électrons (16) qui est en contact avec la couche émettrice (15) ou le matériau hôte est un composé ayant deux groupes carbazolyle ou groupes tétrahydrocarbazolyle.

**6.** Dispositif électroluminescent organique (100) selon la revendication 1, dans lequel le matériau de transport d'électrons formant la couche de transport d'électrons (16) qui est en contact avec la couche émettrice (15) ou le matériau hôte est un composé ayant un groupe carbazolyle ou un groupe tétrahydrocarbazolyle, et un groupe à hétérocycle contenant de l'azote.

**7.** Dispositif électroluminescent organique (100) selon la revendication 1, dans lequel une différence ($\Delta Ip$ = Ip (matériau de transport d'électrons) - Ip (matériau hôte)) de potentiel d'ionisation entre le matériau hôte formant la couche émettrice (15) et le matériau de transport d'électrons formant la couche de transport d'électrons (16) qui est en contact avec la couche émettrice (15) est $-0,2\ eV < \Delta Ip < 0,4\ eV$.

**8.** Dispositif électroluminescent organique (100) selon la revendication 1, présentant une pluralité de couches de transport d'électrons (16).

**9.** Dispositif électroluminescent organique (100) selon la revendication 8, dans lequel une différence ($\Delta Ip'$), représentée par l'expression suivante, de potentiel d'ionisation entre des matériaux de transport d'électrons formant deux couches adjacentes de la pluralité de couches de transport d'électrons (16) est $-0,2\ eV < \Delta Ip' < 0,4\ eV$,

$$\Delta Ip' = Ip(i) - Ip(i + 1)$$

dans lequel Ip (i) est le potentiel d'ionisation d'un matériau de transport d'électrons formant une i-ème couche de transport d'électrons (16) à partir de la couche émettrice (15), i est un entier de 1 ou plus et (N-1) ou moins, et N est le nombre des couches de transport d'électrons (16).

**10.** Dispositif électroluminescent organique (100) selon la revendication 8, dans lequel la bande interdite optique (Eg) d'un matériau de transport d'électrons formant une couche de transport d'électrons (16) est égale à ou inférieure à la bande interdite optique (Eg) d'un matériau de transport d'électrons formant la couche de transport d'électrons adjacente (16) la plus proche de la couche émettrice (15).

**11.** Dispositif électroluminescent organique (100) selon la revendication 8, dans lequel la bande interdite de triplet d'un matériau de transport d'électrons formant une couche de transport d'électrons (16) est égale à ou est plus petite que la bande interdite de triplet d'un matériau de transport d'électrons formant la couche de transport d'électrons adjacente (16) la plus proche de la couche émettrice (15).

**12.** Dispositif électroluminescent organique (100) selon la revendication 1, dans lequel la bande interdite de triplet du matériau de transport d'électrons formant la couche de transport d'électrons (16) qui est en contact avec la couche émettrice (15) est plus grande que la bande interdite de triplet du composé complexe métallique de la couche émettrice (15).

FIG. 1

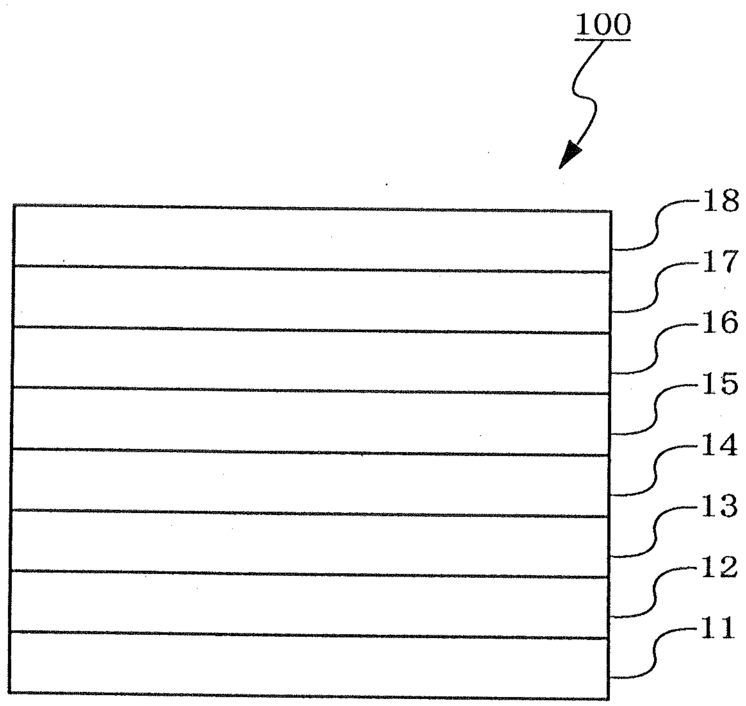

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 63295695 A
- US 6097147 A
- JP 2002203683 A
- US 20020055014 A1
- US 20030072965 A1
- US 20020055014 A
- US 20030205696 A1
- US 20020096995 A1
- JP 2002305375 A
- JP 2003067847 A
- JP 5141671 B
- JP 2002071398 A
- JP 2002081234 A
- JP 2002071397 A
- JP 2002080817 A
- JP 2002360134 A
- JP 2002299810 A
- JP 10237438 A
- JP 2003042625 A
- JP 2002299814 A
- JP 2002083866 A
- JP 2002087560 A


### Non-patent literature cited in the description


- **TSUTSUI et al.** *Japanese Journal of Physics,* 1999, vol. 38, 1502-1504
- The World of Photochemistry. Chemical Society of Japan, 1993, 50